(19) Europäisches Patentamt
European Patent Office
Office européen des brevets

(11) **EP 4 343 434 A1**

(12) **EUROPEAN PATENT APPLICATION**
published in accordance with Art. 153(4) EPC

(43) Date of publication:
**27.03.2024 Bulletin 2024/13**

(21) Application number: **22810202.6**

(22) Date of filing: **02.04.2022**

(51) International Patent Classification (IPC):
***G03F 7/027*** *(2006.01)*

(52) Cooperative Patent Classification (CPC):
**C08F 2/48; C08F 220/30; C08F 220/54; C08F 222/22; C08F 226/06; C08F 226/10; C08F 283/00; C08G 18/32; C08G 18/42; C08G 18/50; G03F 7/027; G03H 1/02**

(86) International application number:
**PCT/CN2022/085089**

(87) International publication number:
**WO 2022/247469 (01.12.2022 Gazette 2022/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.05.2021 CN 202110563230**

(71) Applicant: **Huawei Technologies Co., Ltd.**
**Longgang**
**Shenzhen, Guangdong 518129 (CN)**

(72) Inventors:
- **PENG, Haiyan**
  **Wuhan, Hubei 430074 (CN)**
- **XU, Shaoqin**
  **Wuhan, Hubei 430074 (CN)**
- **XIE, Xiaolin**
  **Wuhan, Hubei 430074 (CN)**
- **ZHOU, Xingping**
  **Wuhan, Hubei 430074 (CN)**
- **YAO, Ming**
  **Wuhan, Hubei 430074 (CN)**
- **QIU, Botong**
  **Shenzhen, Guangdong 518129 (CN)**

(74) Representative: **Huawei European IPR**
**Huawei Technologies Duesseldorf GmbH**
**Riesstraße 25**
**80992 München (DE)**

# (54) HOLOGRAPHIC RECORDING MEDIUM, HOLOGRAPHIC POLYMER MATERIAL AND PREPARATION METHOD THEREFOR, AND DISPLAY DEVICE

(57) Embodiments of this application provide a holographic recording medium, a holographic polymer material, a preparation method therefor, and a display device, which may be used in fields of data storage, anti-counterfeiting images, holographic optical elements, holographic display, and the like. The holographic recording medium of the holographic polymer material before exposure includes a first-order crosslinked network, a photoinitiator, and a second-order monomer. The first-order crosslinked network provides a mechanical support for the holographic recording medium. The second-order monomer is a monomer with a free radical reactivity. The photoinitiator is used to initiate polymerization of the second-order monomer. The holographic recording medium includes an ester group (I), a urethane group (II), a carbamido group (III), an allophanate group (IV), and an amide group (V). Groups linked to the ester group (1), the urethane group (II), the carbamido group (III), the allophanate group (IV), and the amide group (V) are separately selected from at least one of the following: alkyl, alkoxy, alkenyl, or aryl. The holographic recording medium can be used to prepare a holographic polymer material with high diffraction efficiency and a high transmittance.

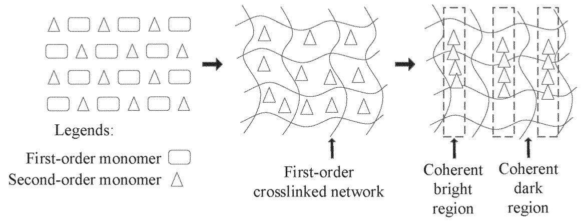


FIG. 1

EP 4 343 434 A1

## Description

### CROSS-REFERENCE TO RELATED APPLICATIONS

This application claims priority to Chinese Patent Application No. 202110563230.9, filed with the China National Intellectual Property Administration on May 24, 2021 and entitled "HOLOGRAPHIC RECORDING MEDIUM, HOLOGRAPHIC POLYMER MATERIAL, PREPARATION METHOD THEREFOR, AND DISPLAY DEVICE", which is incorporated herein by reference in its entirety.

### TECHNICAL FIELD

This application relates to the field of polymer resin materials, and in particular, to a holographic recording medium, a holographic polymer material, a preparation method therefor, and a display device.

### BACKGROUND

A crosslinked-network-based holographic polymer material features solvent-free preparation, ease of processing, a stable size, thick film recording, and the like. The holographic polymer material plays an important role in many fields. The holographic polymer material is mainly obtained through polymerization reactions in two stages. In a first stage, a non-free radical reactive monomer (referred to as a first-order monomer) forms a first-order crosslinked network through a polymerization reaction, to provide a mechanical support, and a free radical reactive monomer (referred to as a second-order monomer) is stabilized in the first-order crosslinked network for subsequent holographic recording. The second-order monomer does not react in a process of forming the first-order crosslinked network. In a second stage, a photoinitiator generates a free radical under irradiation of a coherent laser, so that the second-order monomer undergoes a photopolymerization reaction in a coherent bright region, to induce a monomer in a coherent dark region to diffuse to the coherent bright region and participate in the photopolymerization reaction, making polymer densities and refractive indexes of the coherent bright region and the coherent dark region different. Holographic information is recorded in a form of a holographic grating. Currently, in most cases, micro-phase separation from the first-order crosslinked network occurs on a polymer generated after the photopolymerization reaction of the second-order monomer in the coherent bright region. As a micro-phase separation degree increases in a photopolymerization reaction process, diffraction efficiency increases, but a transmittance decreases. Consequently, it is difficult to prepare a holographic polymer material with high diffraction efficiency and a high transmittance.

### SUMMARY

This application provides a holographic recording medium, a holographic polymer material, a preparation method therefor, and a display device, to achieve advantages of high diffraction efficiency and a high transmittance of the holographic polymer material.

According to a first aspect, this application provides a holographic recording medium, including a first-order crosslinked network, a photoinitiator, and a second-order monomer. The first-order crosslinked network provides a mechanical support for the holographic recording medium. The second-order monomer is a monomer with a free radical reactivity. The photoinitiator is used to absorb light and generate a free radical, to polymerize the second-order monomer. The holographic recording medium includes an ester group (1), a urethane group (II), a carbamido group (III), an allophanate group (IV), and an amide group (V). Groups linked to the ester group (1), the urethane group (II), the carbamido group (III), the allophanate group (IV), and the amide group (V) are separately selected from at least one of the following: alkyl, alkoxy, alkenyl, or aryl.

According to the holographic recording medium provided in this application, the ester group (I), the urethane group (II), the carbamido group (III), the allophanate group (IV), and the amide group (V) are introduced, so that compatibility between monomers and between the second-order monomer and the first-order crosslinked network can be increased on the one hand, and phase separation of a polymer generated by the second-order monomer from the first-order crosslinked network can be suppressed on the other hand. Therefore, a holographic polymer material with a high transmittance and high diffraction efficiency can be prepared.

In a possible implementation of this application, the second-order monomer accounts for 10% to 80% of a total weight of the holographic recording medium, and may further account for 30% to 70%. A weight percentage of the second-order monomer in the holographic recording medium is limited, and a weight percentage of the photoinitiator in the holographic recording medium is low, which is about 0.1% to 3%. This is equivalent to that a weight percentage of the first-order crosslinked network in the holographic recording medium is also limited. Therefore, a finally obtained holographic polymer material has a high transmittance and high diffraction efficiency.

In a possible implementation of this application, after being illuminated, the holographic recording medium includes at least one of the following: the ester group (1), the urethane group (II), the carbamido group (III), the allophanate group (IV), and the amide group (V). Therefore, the holographic recording medium includes at least one of the following: the ester group (1), the urethane group (II), the carbamido group (III), the allophanate group (IV), and the amide group (V) before and after illumination. In this way, the compatibility between the monomers and between the second-order monomer and the first-order crosslinked network can be improved, and in addition, phase separation of the second-order polymer generated through a photopolymerization reaction of the second-order monomer from the first-order crosslinked network can be suppressed in a holographic recording process. Therefore, both the transmittance and the diffraction efficiency of the holographic polymer material are improved.

In a possible implementation of this application, the holographic recording medium includes at least one of the following: the ester group (I), the urethane group (II), the carbamido group (III), the allophanate group (IV), and the amide group (V), so that an infrared spectrum of the holographic recording medium includes a first characteristic absorption peak and a second characteristic absorption peak. A wave number range of the first characteristic absorption peak is 1760 $cm^{-1}$ to 1650 $cm^{-1}$. A wave number range of the second characteristic absorption peak is 1650 $cm^{-1}$ to 1610 $cm^{-1}$. A non-reactive polar group included in the holographic recording medium may be characterized by using the wave number ranges of the two characteristic absorption peaks of the infrared spectrum. The holographic recording medium of which the infrared spectrum includes the first characteristic absorption peak whose wave number range is 1760 $cm^{-1}$ to 1650 $cm^{-1}$ and the second characteristic absorption peak whose wave number range is 1650 $cm^{-1}$ to 1610 $cm^{-1}$ is selected, so that a holographic polymer material with a high transmittance and high diffraction efficiency can be prepared.

In a possible implementation of this application, a ratio of a peak area of the first characteristic absorption peak to a peak area of the second characteristic absorption peak ranges from 5 to 30. The holographic recording medium whose ratio of the peak area of the first characteristic absorption peak to the peak area of the second characteristic absorption peak ranges from 5 to 30 is used, so that a ratio of a peak area of a first characteristic absorption peak to a peak area of a second characteristic absorption peak of an infrared spectrum of a prepared polymer material ranges from 0.5 to 5. Therefore, the prepared holographic polymer material can have a high transmittance and high diffraction efficiency.

In a possible implementation of this application, the second-order monomer includes at least one of the following: acrylate, methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic acid, and acrylic acid. With these second-order monomers, the holographic recording medium may include at least one of the following: the ester group (1), the urethane group (II), the carbamido group (III), the allophanate group (IV), and the amide group (V), so that the compatibility between the monomers and between the second-order monomer and the first-order crosslinked network can be increased on the one hand, and phase separation of the polymer generated by the second-order monomer from the first-order crosslinked network can be suppressed on the other hand.

In a possible implementation of this application, a refractive index of at least one second-order monomer is greater than 1.505. A high refractive index of the second-order monomer helps improve a refractive index contrast between the second-order monomer and the first-order monomer, and makes it easier to implement both a high transmittance and high diffraction efficiency.

In a possible implementation of this application, the first-order crosslinked network is generated through a polymerization reaction of the first-order monomer, and the first-order monomer generally does not have a free radical reactivity. Therefore, when the holographic recording medium is illuminated, the first-order monomer does not undergo the photopolymerization reaction, which can avoid interference to a subsequent photopolymerization reaction.

In a possible implementation of this application, the photoinitiator includes at least one of the following: benzoin and a derivative thereof, benzyl ketal, an acrylphosphine oxide, ketocoumarin, amino acid, rose bengal, methylene blue, a triazine compound, and alkylamine. With these photo initiators, efficiency of the photopolymerization reaction can be improved.

According to a second aspect, this application further provides a method for preparing a holographic recording medium. The preparation method includes the following steps: mixing a first-order monomer, a second-order monomer, and a photoinitiator at room temperature to obtain a mixed solution; and performing curing treatment on the mixed solution, so that the first-order monomer undergoes a polymerization reaction to generate a first-order crosslinked network, to obtain a holographic recording medium. The holographic recording medium includes at least one of the following: an ester group (1), a urethane group (II), a carbamido group (III), an allophanate group (IV), and an amide group (V).

According to the holographic recording medium prepared in this application, the ester group (I), the urethane group (II), the carbamido group (III), the allophanate group (IV), and the amide group (V) are introduced, so that compatibility between monomers and between the second-order monomer and the first-order crosslinked network in the holographic recording medium can be increased on the one hand, and phase separation of a polymer generated by the second-order monomer from the first-order crosslinked network can be suppressed during preparation of a holographic

polymer material on the other hand. Therefore, a holographic polymer material with a high transmittance and high diffraction efficiency can be prepared.

According to a third aspect, this application further provides a holographic polymer material. The holographic polymer material includes a first-order crosslinked network and a second-order polymer. The first-order crosslinked network provides a mechanical support for the holographic polymer material. The second-order polymer is used to form a refractive index distribution for recording holographic information. The holographic polymer material includes at least one of the following: an ester group (1), a urethane group (II), a carbamido group (III), an allophanate group (IV), and an amide group (V). Groups linked to the ester group (1), the urethane group (II), the carbamido group (III), the allophanate group (IV), and the amide group (V) are separately selected from at least one of the following: alkyl, alkoxy, alkenyl, or aryl. The holographic polymer material has advantages of a high transmittance and high diffraction efficiency.

In a possible implementation of this application, the holographic polymer material includes at least one of the following: the ester group (1), the urethane group (II), the carbamido group (III), the allophanate group (IV), and the amide group (V), so that an infrared spectrum of the holographic polymer material includes a first characteristic absorption peak and a second characteristic absorption peak. A wave number range of the first characteristic absorption peak is 1760 $cm^{-1}$ to 1702 $cm^{-1}$. A wave number range of the second characteristic absorption peak is 1702 $cm^{-1}$ to 1640 $cm^{-1}$. A non-reactive polar group included in the holographic polymer material may be represented using the wave number ranges of the two characteristic absorption peaks of the infrared spectrum, so that the holographic polymer material has a high transmittance and high diffraction efficiency.

In a possible implementation of this application, a ratio of a peak area of the first characteristic absorption peak to a peak area of the second characteristic absorption peak ranges from 0.5 to 5. Therefore, the holographic polymer material has a high transmittance and high diffraction efficiency.

In a possible implementation of this application, the second-order polymer is generated by polymerizing a second-order monomer under initiation of a free radical. The second-order monomer is a monomer with a free radical reactivity. The second-order monomer includes at least one of the following: acrylate, methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic acid, and acrylic acid. With these second-order monomers, the holographic polymer material may include at least one of the following: the ester group (1), the urethane group (II), the carbamido group (III), the allophanate group (IV), and the amide group (V), so that phase separation of the polymer generated by the second-order monomer from the first-order crosslinked network can be suppressed.

In a possible implementation of this application, a refractive index of at least one second-order monomer is greater than 1.505. A high refractive index of the second-order monomer helps improve a refractive index contrast between the second-order monomer and the first-order monomer, and makes it easier to implement both a high transmittance and high diffraction efficiency.

According to a fourth aspect, this application further provides a method for preparing a holographic polymer material. The preparation method includes the following steps: mixing a first-order monomer, a second-order monomer, and a photoinitiator at room temperature to obtain a mixed solution; performing curing treatment on the mixed solution, so that the first-order monomer undergoes a polymerization reaction to generate a first-order crosslinked network, to obtain a holographic recording medium; and exposing the holographic recording medium under coherent light to obtain a holographic polymer material recording holographic information. The holographic polymer material prepared in this application has advantages of a high transmittance and high diffraction efficiency.

In a possible implementation of this application, the first-order monomer includes at least one of the following: polyol, polyepoxy, polyvinyl ether, polyamine, and polyisocyanate. With these first-order monomers, the prepared holographic recording medium may include at least one of the following: an ester group (I), a urethane group (II), a carbamido group (III), an allophanate group (IV), and an amide group (V), so that compatibility between monomers and between the second-order monomer and the first-order crosslinked network in the holographic recording medium can be increased on the one hand, and phase separation of a polymer generated by the second-order monomer from the first-order crosslinked network can be suppressed during preparation of the holographic polymer material on the other hand. Therefore, a holographic polymer material with a high transmittance and high diffraction efficiency can be prepared.

In a possible implementation of this application, the method further includes: performing post-treatment on the holographic polymer material, where post-treatment includes illumination or heating. Through a post-treatment step, the second-order monomer that does not completely react in the photopolymerization reaction further reacts. Therefore, a monomer conversion rate is improved.

In a possible implementation of this application, the method further includes: adding a nitrogen-containing polar monomer to the mixed solution. A specific amount of polar monomer is added to the mixed solution, so that dissolution of the photoinitiator in a monomer (for example, the second-order monomer, or the first-order monomer) can be promoted.

In a possible implementation of this application, the nitrogen-containing polar monomer may be one or more of the following: N-vinylpyrrolidone and N,N-dimethylacrylamide. The N-vinylpyrrolidone and the N,N-dimethylacrylamide can not only promote dissolution of the photoinitiator in the monomer, but also participate in the photopolymerization

reaction to prevent a solvent residue from affecting material performance.

In a possible implementation of this application, curing treatment is performed on the mixed solution, so that a thickness of the holographic polymer material is controlled to range from 5 micrometers (μm) to 50 μm, which may further range from 10 μm to 30 μm. Therefore, a holographic polymer material with a high transmittance and diffraction efficiency can be prepared.

According to a fifth aspect, this application further provides a display device. The storage device is obtained by using the holographic recording medium in the first aspect and any possible implementation of the first aspect through a photopolymerization reaction, or includes the holographic polymer material in the third aspect and any possible implementation of the third aspect. The display device is, for example, a head up display (head up display, HUD) device.

According to a sixth aspect, this application further provides a storage device. The storage device is obtained by using the holographic recording medium in the first aspect and any possible implementation of the first aspect through a photopolymerization reaction, or includes the holographic polymer material in the third aspect and any possible implementation of the third aspect. The storage device may be, for example, a holographic memory (holographic memory).

According to a seventh aspect, this application further provides an anti-counterfeiting label. The anti-counterfeiting label is obtained by using the holographic recording medium in the first aspect and any possible implementation of the first aspect through a photopolymerization reaction, or includes the holographic polymer material in the third aspect and any possible implementation of the third aspect.

For beneficial effects of the fifth aspect and the sixth aspect, refer to the beneficial effects of the first aspect or the third aspect. Details are not described herein again.

## BRIEF DESCRIPTION OF DRAWINGS

FIG. 1 is a schematic diagram of preparation of a holographic polymer material according to an embodiment of this application;

FIG. 2 is a flowchart of a method for preparing a holographic recording medium according to an embodiment of this application;

FIG. 3 is a schematic diagram of an optical path of reflective holographic recording according to an embodiment of this application;

FIG. 4 is a flowchart of a method for preparing a holographic polymer material according to an embodiment of this application;

FIG. 5 is a schematic diagram of a process of preparing a holographic polymer material according to Embodiment 1 of this application;

FIG. 6 is a diagram of an infrared spectrum of a holographic polymer material prepared according to Embodiment 1 of this application;

FIG. 7 is a diagram of an ultraviolet-visible absorption spectrum of a holographic polymer material prepared according to Embodiment 1;

FIG. 8 is a diagram of an infrared spectrum of a holographic polymer material prepared according to Embodiment 3;

FIG. 9 is a diagram of an ultraviolet-visible absorption spectrum of a holographic polymer material prepared according to Embodiment 3;

FIG. 10 is a diagram of an infrared spectrum of a holographic polymer material prepared according to Embodiment 5;

FIG. 11 is a diagram of an ultraviolet-visible absorption spectrum of a holographic polymer material prepared according to Embodiment 5;

FIG. 12 is a diagram of an infrared spectrum of a holographic polymer material prepared according to Embodiment 28;

FIG. 13 is a diagram of an ultraviolet-visible absorption spectrum of a holographic polymer material prepared according to Embodiment 28;

FIG. 14 is a diagram of an infrared spectrum of a holographic polymer material prepared according to Embodiment 30, and

FIG. 15 is a diagram of an ultraviolet-visible absorption spectrum of a holographic polymer material prepared according to Embodiment 30.

## DESCRIPTION OF EMBODIMENTS

To make objectives, technical solutions, and advantages of this application clearer, the following further describes this application in detail with reference to the accompanying drawings.

Terms used in the following embodiments are merely for the purpose of describing specific embodiments, but are not intended to limit this application. As used in the specification of this application and the appended claims, the

singular expression "a", "an", "the foregoing", "the", or "this" is intended to also include expressions such as "one or more", unless otherwise clearly indicated in the context.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include" and "have" and their variants all mean "include but are not limited to", unless otherwise specifically emphasized in another manner.

For ease of understanding, some terms in the following embodiments of this application are first described as an example.

(1) A holographic polymer material is a polymer material that records holographic information.

(2) Holographic recording is a process of recording all information such as an amplitude and a phase of coherent light through a photopolymerization reaction under irradiation of the coherent laser.

(3) A first-order monomer is a monomer capable of forming a first-order crosslinked network through anionic polymerization, cationic polymerization, step-growth polymerization, or the like.

(4) The first-order crosslinked network is a mechanical skeletal structure formed by chemical reactions such as anionic polymerization, cationic polymerization, or step-growth polymerization, which can stabilize a monomer with a free radical reactivity to prevent a material from flowing at room temperature.

(5) A non-free radical reactive monomer means that an active center in a monomer polymerization process is not a free radical.

(6) A second-order monomer is a monomer that is stabilized by the first-order crosslinked network and can undergo free radical polymerization.

(7) A non-photoreactive polar group is a group that does not react during photopolymerization of the second-order monomer and whose positive and negative charge centers do not coincide.

(8) A second-order polymer is a polymer generated through photopolymerization of the second-order monomer under an action of a photoinitiator under irradiation of a coherent laser.

(9) An orthogonal chemical reaction means that polymerization reaction mechanisms of the first-order monomer and the second-order monomer are different and two reactions do not interfere with each other and can be independently controlled. Specifically, a polymerization reaction of the first-order monomer may be one or more of the following: anionic polymerization, cationic polymerization, and step-growth polymerization, and is different from a free radical polymerization reaction mechanism of the second-order monomer.

(10) A weight percentage may also be expressed as wt%.

(11) "At least one type (piece)" means one or more types (pieces), and "a plurality of" means two or more. "And/or" describes an association relationship between associated objects, and indicates that three relationships may exist. For example, A and/or B may indicate the following cases: Only A exists, both A and B exist, and only B exists. A and B each may be singular or plural. The character "/" generally indicates an "or" relationship between the associated objects. "At least one of the following items (types)" or a similar expression thereof means any combination of these items, including a single item (type) or any combination of a plurality of items (types). For example, at least one item (type) of a, b, or c may indicate: a, b, c, a and b, a and c, b and c, or a, b and c, where a, b, and c may be singular or plural.

In addition, unless otherwise stated, ordinal terms such as "first" and "second" mentioned in embodiments of this application are used to distinguish between a plurality of objects, and are not intended to limit sequences, time sequences, priorities, or importance degrees of the plurality of objects. For example, a first characteristic absorption peak and a second characteristic absorption peak are merely used to distinguish between different characteristic absorption peaks, but do not indicate different priorities, sequences, importance degrees, or the like of the two characteristic absorption peaks.

A holographic polymer material is mainly obtained through polymerization reactions in two stages. As shown in FIG. 1, in a first stage, a non-free radical reactive monomer (referred to as a first-order monomer) forms a first-order crosslinked network through a polymerization reaction (for example, anionic polymerization, cationic polymerization, or step-growth polymerization), and a free radical reactive monomer (referred to as a second-order monomer) is stabilized in the first-order crosslinked network, to facilitate subsequent holographic recording. Through an orthogonal chemical reaction design, the second-order monomer does not react in a process of forming the first-order crosslinked network. A polymerization reaction in a second stage is a holographic photopolymerization reaction. To be specific, under irradiation of a coherent laser, the second-order monomer undergoes a photopolymerization reaction (generally free radical polymerization) in a coherent bright region, to induce a monomer in a coherent dark region to diffuse to the coherent bright region and participate in the photopolymerization reaction, to generate a second-order polymer, making polymer densities

and refractive indexes of the coherent bright region and the coherent dark region different. Holographic information is recorded in a form of a holographic grating. In the conventional technology, material performance is mainly controlled by changing a monomer structure. However, it is not pointed out how a chemical structure of the holographic polymer material obtained after the polymerization reactions of the monomers affects the material performance of the holographic polymer material. As a result, a relationship between the structure and the performance of the holographic polymer material is still a black box. In the conventional technology, diffraction efficiency is controlled only by changing the monomer structure. However, in most cases, micro-phase separation from the first-order crosslinked network occurs on the polymer generated after the photopolymerization reaction of the second-order monomer in the coherent bright region. As a micro-phase separation degree increases in a photopolymerization reaction process, diffraction efficiency increases, but a transmittance decreases. Consequently, it is difficult to prepare a holographic polymer material with high diffraction efficiency and a high transmittance.

To resolve the foregoing technical problem, an embodiment of this application provides a holographic recording medium. The holographic recording medium includes a first-order crosslinked network, a photoinitiator, and a second-order monomer. The first-order crosslinked network provides a mechanical support for the holographic recording medium. The second-order monomer is a monomer with a free radical reactivity. The photoinitiator is used to absorb light and generate a free radical, to polymerize the second-order monomer. The holographic recording medium includes at least one of the following: an ester group (1), a urethane group (II), a carbamido group (III), an allophanate group (IV), and an amide group (V). Groups linked to the ester group (1), the urethane group (II), the carbamido group (III), the allophanate group (IV), and the amide group (V) are separately selected from at least one of the following: alkyl, alkoxy, alkenyl, or aryl.

The first-order crosslinked network in the holographic recording medium includes at least one of the following: the ester group (1), the urethane group (II), the carbamido group (III), the allophanate group (IV), and the amide group (V), and/or the second-order monomer includes at least one of the following: the ester group (1), the urethane group (II), the carbamido group (III), the allophanate group (IV), and the amide group (V). Further, both the first-order crosslinked network and the second-order monomer include at least one of the following: the ester group (I), the urethane group (II), the carbamido group (III), the allophanate group (IV), and the amide group (V). In this way, compatibility between second-order monomers and between the second-order monomer and the first-order crosslinked network can be improved better, and in addition, phase separation of a second-order polymer generated through a photopolymerization reaction of the second-order monomer from the first-order crosslinked network can be suppressed in a holographic recording process. Therefore, both a transmittance and diffraction efficiency of a holographic polymer material are improved.

In an example, a structure of the ester group (1) included in the holographic recording medium is as follows:

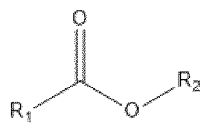

$R_1$ and $R_2$ are separately selected from at least one of the following: alkyl, alkoxy, alkenyl, or aryl.

A structure of urethane group (11) included in the holographic recording medium is as follows:

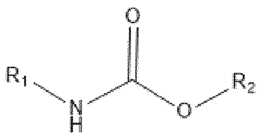

$R_1$, $R_2$, and $R_3$ are separately selected from at least one of the following: alkyl, alkoxy, alkenyl, or aryl.

A structure of the carbamido group (III) in the holographic recording medium is as follows:

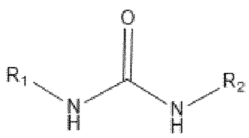

$R_1$ and $R_2$ are separately selected from at least one of the following: alkyl, alkoxy, alkenyl, or aryl.

A structure of the allophanate group (IV) included in the holographic recording medium is as follows:

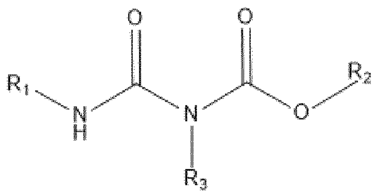

$R_1$, $R_2$, and $R_3$ are separately selected from at least one of the following: alkyl. alkoxy, alkenyl, or aryl.

A structure of the amide group (V) included in the holographic recording medium is as follows:

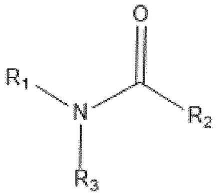

$R_1$, $R_2$, and $R_3$ are separately selected from at least one of the following: alkyl, alkoxy, alkenyl, or aryl.

In an embodiment of this application, the second-order monomer accounts for 10% to 80% of a total weight of the holographic recording medium, and may further account for 30% to 70%. In an example, content of the second-order monomer may be, for example, 10%, 20%, 30%, 40%, 50%, 60%, 70%, or 80%.

A weight percentage of the second-order monomer in the holographic recording medium is limited, and a weight percentage of the photoinitiator in the holographic recording medium is low, which is about 0.1% to 3%. This is equivalent to that a weight percentage of the first-order crosslinked network in the holographic recording medium is also limited. Therefore, a finally obtained holographic polymer material has a high transmittance and high diffraction efficiency.

A molecular weight of the second-order monomer may range, for example, from 30 g/mol to 3000 g/mol.

In an embodiment of this application, after being illuminated, the holographic recording medium includes at least one of the following: the ester group (1), the urethane group (II), the carbamido group (III), the allophanate group (IV), and the amide group (V). Therefore, the holographic recording medium includes at least one of the following: the ester group (I), the urethane group (II), the carbamido group (III), the allophanate group (IV), and the amide group (V) before and after illumination. In this way, the compatibility between the monomers and between the second-order monomer and the first-order crosslinked network can be improved, and in addition, phase separation of the second-order polymer generated through a photopolymerization reaction of the second-order monomer from the first-order crosslinked network can be suppressed in a holographic recording process. Therefore, both the transmittance and the diffraction efficiency of the holographic polymer material are improved.

In an embodiment of this application, the holographic recording medium includes at least one of the following: the ester group (I), the urethane group (II), the carbamido group (III), the allophanate group (IV), and the amide group (V), so that an infrared spectrum of the holographic recording medium includes a first characteristic absorption peak and a second characteristic absorption peak. A wave number range of the first characteristic absorption peak is 1760 $cm^{-1}$ to 1650 $cm^{-1}$. A wave number range of the second characteristic absorption peak is 1650 $cm^{-1}$ to 1610 $cm^{-1}$. A non-reactive polar group included in the holographic recording medium may be characterized by using the wave number ranges of the two characteristic absorption peaks of the infrared spectrum. The holographic recording medium of which the infrared spectrum includes the first characteristic absorption peak whose wave number range is 1760 $cm^{-1}$ to 1650 $cm^{-1}$ and the second characteristic absorption peak whose wave number range is 1650 $cm^{-1}$ to 1610 $cm^{-1}$ is selected, so that a holographic polymer material with a high transmittance and high diffraction efficiency can be prepared.

In an embodiment of this application, a ratio of a peak area of the first characteristic absorption peak to a peak area of the second characteristic absorption peak ranges from 5 to 30. With the holographic recording medium whose ratio of the peak area of the first characteristic absorption peak to the peak area of the second characteristic absorption peak ranges from 5 to 30, a ratio of a peak area of a first characteristic absorption peak to a peak area of a second characteristic absorption peak of an infrared spectrum of a prepared polymer material ranges from 0.5 to 5. Therefore, the prepared holographic polymer material can have a high transmittance and high diffraction efficiency. Further, the ratio of the peak area of the first characteristic absorption peak to the peak area of the second characteristic absorption peak may be 10 to 20, so that the prepared holographic polymer material can have a higher transmittance and higher diffraction efficiency. In an example, the ratio of the peak area of the first characteristic absorption peak to the peak area of the second characteristic absorption peak may be, for example, 5, 10, 15, 20, 25, or 30.

In an embodiment of this application, the second-order monomer includes at least one of the following: acrylate,

methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic acid, and acrylic acid. Further, the second-order monomer is preferably the acrylate and the acrylamide, further preferably the acrylate.

In an embodiment of this application, the acrylate includes but is not limited to methyl acrylate, methyl methacrylate, ethyl acrylate, ethyl methacrylate, trimethylolpropane triacrylate, triethylene glycol dimethacrylate, phenyl methacrylate, 1,6-hexanediol diacrylate, 2-ethylhexyl acrylate, ethyl acrylate, trimethylolpropane trimethacrylate, trolox, 2-(perfluorooctyl)ethyl methacrylate, neopentyl glycol diacrylate, 1,4-butanediol diacrylate, ethoxyethyl acrylate, ethoxyethyl methacrylate, n-butyl acrylate, n-butyl methacrylate, tert-butyl acrylate, tert-butyl methacrylate, hexyl acrylate, hexyl methacrylate, 2-ethylhexyl acrylate, 2-ethylhexyl methacrylate, butoxyethyl acrylate, butoxyethyl methacrylate, lauryl acrylate, lauryl methacrylate, isobornyl acrylate, isobornyl methacrylate, phenylacrylate, p-chlorophenyl acrylate, p-chlorophenyl methacrylate, p-bromophenyl acrylate, p-bromophenyl methacrylate, trichlorophenyl acrylate, trichlorophenyl methacrylate, tribromophenyl acrylate, tribromophenyl methacrylate, pentachlorophenyl acrylate, pentachlorophenyl methacrylate, pentabromophenyl acrylate, pentabromophenyl methacrylate, pentabromophenyl methyl acrylate, pentabromophenyl methyl methacrylate, phenoxyethyl acrylate, phenoxyethyl methacrylate, phenoxy-ethoxy ethyl acrylate, and dicyclopentenyl acrylate. In particular, an acrylate monomer with a high refractive index ($n>1.5$) is preferably used, for example, one or a mixture of 1,3-bis(phenylthio)-2-propyl acrylate, 2-([1,1'-biphenyl]-2-yloxy)ethyl acrylate, and 3-(9H-carbazole-9-yl)propane-1,2-diacrylate.

In this embodiment of this application, a refractive index of the second-order monomer may be greater than 1.505, or may be less than or equal to 1.505. For example, refractive indexes of the N,N-dimethvlacrylamide, the acrylate, and the like are less than 1.505.

In an embodiment of this application, a refractive index of at least one second-order monomer is greater than 1.505. A high refractive index of the second-order monomer helps improve a refractive index contrast between the second-order monomer and the first-order monomer, and makes it easier to implement both a high transmittance and high diffraction efficiency.

In an embodiment of this application, the first-order crosslinked network is generated through a polymerization reaction of the first-order monomer, and the first-order monomer generally does not have a free radical reactivity. In some other embodiments, if the first-order monomer has a free radical reactivity, but does not affect a free radical polymerization reaction of the second-order monomer, good material performance may also be obtained. Therefore, when the holographic recording medium is illuminated, the first-order monomer does not undergo the photopolymerization reaction, which can avoid interference to a subsequent photopolymerization reaction.

In an embodiment of this application, the first-order monomer includes one or more of the following: polyol, polyepoxy, polyvinyl ether, polyamine, and polyisocyanate.

In an embodiment of this application, the polyol includes but is not limited to one or more of the following: ethylene glycol, 1,2-propanediol, 2,4-dimethyl-2,4-pentanediol, 2-n-pentylpropane-1,3-diol, tripropylene glycol, 1,2-propanediol, 1,3-propanediol, 1,4-butanediol, neopentyl glycol, 2-ethyl-2-butyl propanediol, trimethylpentanediol, 1,3-butanediol, cyclohexanediol, 1,4-cyclohexanedimethanol, 1,6-hexanediol, 1,2-cyclohexanediol, 1,4-cyclohexanediol, 3,3-dimethyl-1,2-butanediol, 1,3-cyclopentanediol, trimethylolethane, trimethylolpropane, glycerol, di(trimethylolpropane), pentaerythritol, dipentaerythritol, sorbitol, and a block copolymer that is terminated by a polyhydroxyl functional group and that contains a non-photoreactive polar group, for example, an ester or urethane.

In an embodiment of this application, the polyepoxy includes but is not limited to one or more of the following: aromatic, aromatic ester, aliphatic, and cycloaliphatic epoxy resins.

In an embodiment of this application, the polyvinyl ether includes but is not limited to one or more of the following: aromatic, aromatic ester, aliphatic, and cycloaliphatic small molecules, oligomers, or polymers with vinyl ether as a terminal group, for example, diethylene glycol divinyl ether, 1,4-butanediol divinyl ether, or polyethylene glycol divinyl ether.

In an embodiment of this application, the polyamine includes but is not limited to ethylenediamine, diethylenetriamine, triethylenetetramine, propane diamine, diaminocyclohexane, diaminobenzene, benzidine, an amine-terminated polymer with a maximum number-average molar mass of 10000 g/mol, or any mixture thereof.

In an embodiment of this application, the polyisocyanate includes but is not limited to one or more of the following: butylidene diisocyanate, hexamethylene diisocyanate (HDI), isophorone diisocyanate (IPDI), 1,8-diisocyanato-4-(isocyanatomethyl)octane, 2,2,4-trimethylhexamethylene diisocyanate, 2,4,4-trimethylhexamethylene diisocyanate, bis(4,4-isocyanatocyclohexyl)methane, isocyanatomethyl-1,8-diisocyanatooctane, 1,4-cyclohexylidene diisocyanate, cyclohexane dimethylene diisocyanate, 1,4-phenylene diisocyanate, 2,4-toluene diisocyanate, 2,6-toluene diisocyanate, 1,5-naphthalene diisocyanate, 2,4-diphenylmethane diisocyanate, 4,4'-diphenylmethane diisocyanate, triphenylmethane-4,4',4"-triisocyanate, 1,3,5-tri(2-isocyanatoethyl)-1,3,5-triazine-2,4,6-trione, 1,3,5-tri(4-isocyanatobutyl)-1,3,5-triazine-2,4,6-trione, 1,3,5-tri(6-isocyanatohexyl)-1,3,5-triazine-2,4,6-trione, 1,3,5-tri(8-isocyanatooctyl)-!,3,5-triazine-2,4,6-trione, and 1,3,5-tri(10-isocyanatodecyl)-1,3,5-triazine-2,4,6-trione.

In an embodiment of this application, the photoinitiator includes at least one of the following: benzoin and a

derivative thereof, benzyl ketal, an acrylphosphine oxide, ketocoumarin, amino acid, rose bengal, methylene blue, a triazine compound, and alkylamine.

Based on a same technical concept, an embodiment of this application further provides a method for preparing a holographic recording medium. As shown in FIG. 2, the preparation method includes the following steps.

S201: Mix a first-order monomer, a second-order monomer, and a photoinitiator at room temperature to obtain a mixed solution.

S202: Perform curing treatment on the mixed solution, so that the first-order monomer undergoes a polymerization reaction to generate a first-order crosslinked network, to obtain a holographic recording medium. The holographic recording medium includes at least one of the following: an ester group (1), a urethane group (II), a carbamido group (III), an allophanate group (IV), and an amide group (V).

According to the holographic recording medium prepared in this application, the ester group (I), the urethane group (II), the carbamido group (III), the allophanate group (IV), and the amide group (V) are introduced, so that compatibility between monomers and between the second-order monomer and the first-order crosslinked network in the holographic recording medium can be increased on the one hand, and phase separation of a polymer generated by the second-order monomer from the first-order crosslinked network can be suppressed during preparation of a holographic polymer material on the other hand. Therefore, a holographic polymer material with a high transmittance and high diffraction efficiency can be prepared.

S201 and S202 should be performed in a dark place or under a safelight. Curing treatment in S202 is not limited to heating by an oven, and other curing manners may also be used.

Content of a monomer and a molecular weight of the monomer affect a ratio of peak areas of two characteristic absorption peaks of an infrared spectrum of the holographic recording medium, that is, a ratio of a first characteristic absorption peak at 1760 $cm^{-1}$ to 1650 $cm^{-1}$ to a second characteristic absorption peak at 1650 $cm^{-1}$ to 1610 $cm^{-1}$. In an embodiment of this application, content of the second-order monomer is 10 wt% to 80 wt%, which may further be 30% to 70%. In an example, the content of the second-order monomer may be, for example, 10%, 20%, 30%, 40%, 50%, 60%, 70%, or 80%.

In an embodiment of this application, a molecular weight of the first-order monomer ranges from 30 g/mol to 3000 g/mol, and a molecular weight of the second-order monomer ranges from 30 g/mol to 3000 g/mol.

In an embodiment of this application, the preparation method further includes: adding a nitrogen-containing polar monomer to the mixed solution. A specific amount of polar monomer is added to the mixed solution, so that dissolution of the photoinitiator in a monomer (for example, the second-order monomer, or the first-order monomer) can be promoted.

In an embodiment of this application, the nitrogen-containing polar monomer may be one or more of the following: N-vinylpyrrolidone and N,N-dimethylacrylamide.

In an embodiment of this application, curing treatment is performed on the mixed solution, so that a thickness of the holographic polymer material is controlled to range from 5 $\mu$m to 50 $\mu$m. Further, the thickness may range from 10 $\mu$m to 30 $\mu$m. Therefore, a holographic polymer material with a high transmittance and diffraction efficiency can be prepared.

In an example, after uniform mixing, the mixed solution including the first-order monomer, the second-order monomer, and the photoinitiator is used in a substrate, and a film may be formed by using technologies such as blade coating, casting, printing, spraying, or inkjet printing. A thickness of the film ranges from 5 $\mu$m to 50 $\mu$m. Further, the thickness may range from 10 $\mu$m to 30 $\mu$m. The substrate may be made of plastic, glass, ceramic, or a composite material including a plurality of these materials, where the plastic is a polymer.

Based on a same technical concept, an embodiment of this application further provides a holographic polymer material, including a first-order crosslinked network and a second-order polymer. The first-order crosslinked network provides a mechanical support for the holographic polymer material. The second-order polymer is used to form a refractive index distribution for recording holographic information. A refractive index of a region in which the second-order polymer is aggregated is high. A region in which there is no second-order polymer or a region in which the second-order polymer is less aggregated may also be understood as a background with a low refractive index. The second-order polymer and the background may form the refractive index distribution for recording the holographic information. FIG. 1 is used as an example. The region in which the second-order polymer is aggregated may also be understood as a coherent bright region in FIG. 1, and the background may be understood as a coherent dark region in FIG. 1.

The holographic polymer material includes at least one of the following: an ester group (1), a urethane group (II), a carbamido group (III), an allophanate group (IV), and an amide group (V). Groups linked to the ester group (1), the urethane group (II), the carbamido group (III), the allophanate group (IV), and the amide group (V) are separately selected from at least one of the following: alkyl, alkoxy, alkenyl, or aryl.

In an embodiment of this application, when the holographic polymer material is used to manufacture a reflective holographic optical element, a transmittance in a range of 400 nm to 700 nm is greater than 80%, and diffraction efficiency is greater than 80%.

In an embodiment of this application, the holographic polymer material includes at least one of the following: the ester group (I), the urethane group (II), the carbamido group (III), the allophanate group (IV), and the amide group (V), so that an infrared spectrum of the holographic polymer material includes a first characteristic absorption peak and a second characteristic absorption peak. A wave number range of the first characteristic absorption peak is 1760 $cm^{-1}$ to 1702 $cm^{-1}$. A wave number range of the second characteristic absorption peak is 1702 $cm^{-1}$ to 1640 $cm^{-1}$.

In an embodiment of this application, a ratio of a peak area of the first characteristic absorption peak to a peak area of the second characteristic absorption peak ranges from 0.5 to 5. Therefore, the holographic polymer material has a high transmittance and high diffraction efficiency. Further, the ratio of the peak area of the first characteristic absorption peak to the peak area of the second characteristic absorption peak may be 1 to 5, so that both the transmittance and the diffraction efficiency of the holographic polymer material are 80%. Further, the ratio of the peak area of the first characteristic absorption peak to the peak area of the second characteristic absorption peak may be 1.1 to 3, so that the transmittance and the diffraction efficiency of the holographic polymer material are higher than the transmittance and the diffraction efficiency that are achieved when the ratio of the peak areas is 1 to 5. Further, the ratio may be 1.2 to 2.5, so that the holographic polymer material can obtain a higher transmittance and higher diffraction efficiency, which may even be 90% or higher. In an example, the ratio of the peak area of the first characteristic absorption peak to the peak area of the second characteristic absorption peak may be, for example, 0.5:1, 1:1, 1.1:1, 1.2:1, 1.3:1, 1.4:1, 1.5:1, 2:1, 2.5:1, 3:1, 4:1, or 5:1.

In an embodiment of this application, the second-order polymer is generated by polymerizing a second-order monomer under initiation of a free radical. The second-order monomer is a monomer with a free radical reactivity. The second-order monomer includes at least one of the following: acrylate, methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic acid, and acrylic acid.

In an embodiment of this application, a refractive index of at least one second-order monomer is greater than 1.505. A high refractive index of the second-order monomer helps improve a refractive index contrast between the second-order monomer and the first-order monomer, and makes it easier to implement both a high transmittance and high diffraction efficiency.

The holographic polymer material may be used in a plurality of fields. In an embodiment of this application, the holographic polymer material may be used in fields of data storage, anti-counterfeiting images, holographic optical elements, holographic display, and the like. Particularly, the holographic polymer material may be used to prepare a reflective holographic grating.

FIG. 3 is a schematic diagram of an optical path of reflective holographic recording.

As shown in FIG. 3, a holographic recording system includes a laser (Laser), a shutter (shutter, SH), a beam splitter (beam splitter, BS), a reflector (M), and a Fourier lens (CL). The laser is configured to generate a laser beam that satisfies a coherence condition. The shutter is configured to control holographic exposure time. The beam splitter is configured to split the beam into coherent light of a same frequency, a constant phase difference, and a consistent vibration direction. The reflector is configured to control a propagation direction of the coherent light. The Fourier lens is configured to collimate an expanded laser beam.

After passing through the shutter, the laser beam that is generated by the laser and that satisfies the coherence condition is split into coherent light in two directions by the beam splitter. The coherent light in the two directions separately illuminates a holographic recording medium, to obtain a holographic polymer material (holographic polymer material, HPM), to implement holographic recording.

Based on a same technical concept, an embodiment of this application further provides a method for preparing a holographic polymer material. For example, the foregoing holographic recording medium in this application is used to prepare a holographic polymer material. The preparation method includes the following step: exposing the holographic recording medium under coherent light to obtain the holographic polymer material recording holographic information.

In an embodiment of this application, the preparation method further includes: performing post-treatment on the holographic polymer material, where post-treatment includes illumination or heating. Illumination is, for example, ultraviolet irradiation. Ultraviolet irradiation is preferably for 1 minute to 20 minutes, further preferably 5 minutes to 10 minutes.

Based on a same technical concept, an embodiment of this application further provides a method for preparing a holographic polymer material. For example, a first-order monomer, a second-order monomer, and a photoinitiator are used to prepare a holographic polymer material. As shown in FIG. 4, the preparation method includes the following steps.

S401: Mix the first-order monomer, the second-order monomer, and the photoinitiator at room temperature to obtain a mixed solution.

S402: Perform curing treatment on the mixed solution, so that the first-order monomer undergoes a polymerization reaction to generate a first-order crosslinked network, to obtain a holographic recording medium. The holographic recording medium includes at least one of the following: an ester group (1), a urethane group (II), a carbamido group (III), an allophanate group (IV), and an amide group (V).

S401 and S402 should be performed in a dark place or under a safelight. Curing treatment in S202 is not limited to heating by an oven, and other curing manners may also be used.

S403: Expose the holographic recording medium under coherent light to obtain the holographic polymer material recording holographic information. The holographic polymer material includes at least one of the following: the ester group (1), the urethane group (II), the carbamido group (III), the allophanate group (IV), and the amide group (V).

In an embodiment of this application, the preparation method further includes: performing post-treatment on the holographic polymer material, where post-treatment includes illumination or heating.

In an embodiment of this application, the preparation method further includes: adding a nitrogen-containing polar monomer to the mixed solution. A specific amount of polar monomer is added to the mixed solution, so that dissolution of the photoinitiator in a monomer (for example, the second-order monomer, or the first-order monomer) can be promoted.

In an embodiment of this application, the nitrogen-containing polar monomer may be one or more of the following: N-vinylpyrrolidone and N,N-dimethylacrylamide.

In an embodiment of this application, curing treatment is performed on the mixed solution, so that a thickness of the holographic polymer material is controlled to range from 5 μm to 50 μm. Further, the thickness may range from 10 μm to 30 μm.

In an example, after uniform mixing, the mixed solution including the first-order monomer, the second-order monomer, and the photoinitiator is used in a substrate, and a film may be formed by using technologies such as blade coating, casting, printing, spraying, or inkjet printing. Athickness of the film ranges from 5 μm to 50 μm. Further, the thickness may range from 10 μm to 30 μm. The substrate may be made of plastic, glass, ceramic, or a composite material including a plurality of these materials.

In an example, before S402, the preparation method may further include solution packaging. Solution packaging may be specifically pouring the mixed solution into a glass box in a dark room. A cavity thickness of the glass box ranges from 5 μm to 50 μm, so that the thickness of the holographic polymer material may be controlled range from 5 μm to 50 μm. Further, the cavity thickness of the glass box ranges from 10 μm to 30 μm, so that the thickness of the holographic polymer material may be controlled to range from 10 μm to 30 μm.

The following further describes the holographic polymer material in this application with reference to specific embodiments and comparison cases. However, this application is not limited to the following embodiments. In the following embodiments, an ester-containing first-order monomer and an ester-containing second-order monomer are selected to prepare a holographic polymer material. When the ester-containing first-order monomer and/or the ester-containing second-order monomer in the following embodiments are/is replaced with at least one of other ester-containing, a urethane group (II)-containing, a carbamido group (III)-containing, an allophanate group (IV)-containing, and an amide group (V)-containing first-order monomers and/or second-order monomers in the foregoing content of this application, and the preparation method and conditions described in the content of this application are used, a prepared holographic polymer material has effect equivalent to or similar to that in the following embodiments.

**Embodiment 1**

A. Solution preparation: Under a low-luminance safelight, 0.4-0.7 wt% of 3,3-carbonylbis(7-diethylaminocoumarin) and 1.0-1.5 wt% of N-phenylglycine are weighed as a photoinitiator (the photoinitiator accounts for 1.4-2.2 wt% of a total weight), and are added to a brown sample bottle. Then, 5 wt% of N-vinylpyrrolidone is added to dissolve a photoinitiation system. Ultrasound treatment is performed for 30 minutes to obtain a uniform solution. 15.4 wt% of isophorone diisocyanate, 34.6 wt% of polycaprolactone oxydiethylene ester, and 45 wt% of 9,9-bis[4-(2-acryloyloxyethyloxy)phenyl]fluorene. Then, ultrasound treatment is performed for 5 minutes to obtain a uniform solution, as shown in (a) in FIG. 5. A structural formula of the polycaprolactone oxydiethylene ester is as follows:

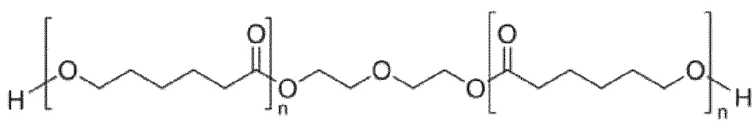

B. Solution packaging: As shown in (b) in FIG. 5, the solution prepared in A is poured into a glass box in a dark room. A cavity thickness of the glass box ranges from 5 μm to 50 μm.

C. Curing: As shown in (c) in FIG. 5, curing is performed at a specific temperature to obtain a film with a thickness of 15 micrometers. The film may be referred to as a holographic recording medium, includes a first-order crosslinked network of a free radical reactive monomer (also referred to as a second-order monomer), and further includes the

photoinitiator.

D. Holographic exposure: As shown in (d) in FIG. 5, an optical path prepared by using a reflective holographic grating is used to expose the holographic recording medium under two 460-nanometer coherent laser beams. For example, light intensity of the laser is 6 $mW/cm^2$ (that is, milliwatt/square centimeter), exposure time is 10 seconds, and a total exposure dose obtained through calculation is 60 $mJ/cm^2$ (that is, millijoule/square centimeter).

E. Post-treatment: Exposure is performed under a high-pressure mercury lamp for 10 minutes, to obtain a holographic polymer material.

An infrared spectrum of the holographic polymer material is tested to determine a molecular composition of the holographic polymer material in this embodiment. FIG. 6 is a diagram of the infrared spectrum of the holographic polymer material prepared according to Embodiment 1.

FIG. 7 is a diagram of an ultraviolet-visible absorption spectrum of the holographic polymer material prepared according to Embodiment 1. It can be learned from FIG. 7 that the holographic polymer material in this embodiment has a high transmittance and high diffraction efficiency.

**Embodiments 2 to 30**

First-order monomers and second-order monomers used in Embodiments 2 to 30 are listed in Table 1, and photoinitiators used in Embodiments 2 to 30 and content thereof are listed in Table 2. For processes of preparing a holographic polymer material in Embodiments 2 to 30, refer to Embodiment 1. For specific process parameters, refer to Table 3.

It should be understood that in infrared spectra of holographic polymer materials prepared according to Embodiments 1 to 30, ratios of a peak area of a first characteristic absorption peak to a peak area of a second characteristic absorption peak range from 0.3 to 5.

**Table** 1

| Serial number | First-order monomer | Second-order monomer | Group included in the holographic recording medium and the holographic polymer material |
|---|---|---|---|
| Embodiment 2 | 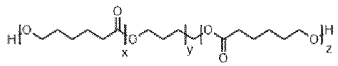 , 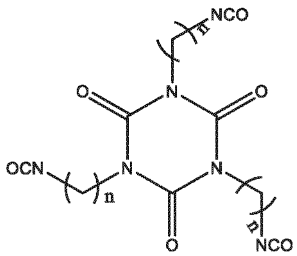 n = 2, 4, 6, 8, 10 | 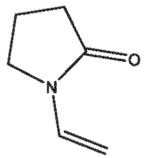 , 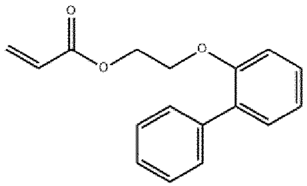 | 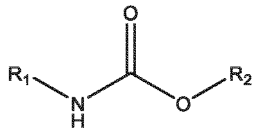 , 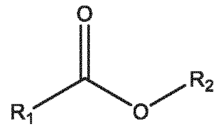 , 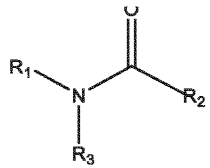 |
| Embodiment 3 | 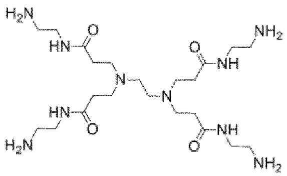 , | 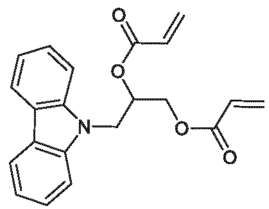 , | 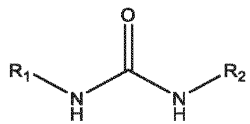 , |

(continued)

| Serial number | First-order monomer | Second-order monomer | Group included in the holographic recording medium and the holographic polymer material |
|---|---|---|---|
| | 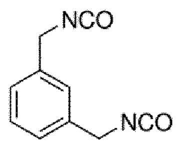 | 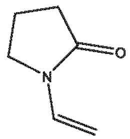 | 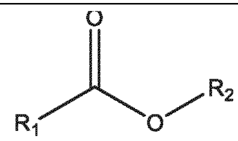 , 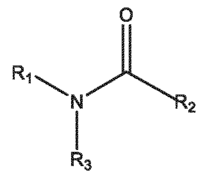 |
| Embodiment 4 | 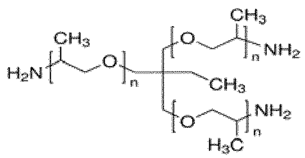 , 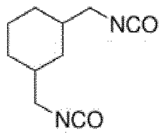 | 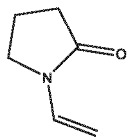 , 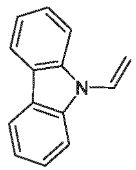 | 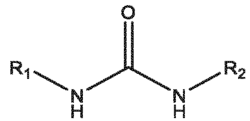 , 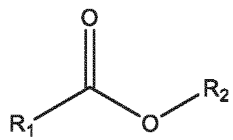 , 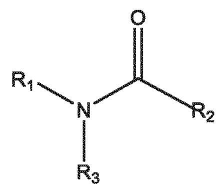 |

(continued)

| Serial number | First-order monomer | Second-order monomer | Group included in the holographic recording medium and the holographic polymer material |
| --- | --- | --- | --- |
| Embodiment 5 | 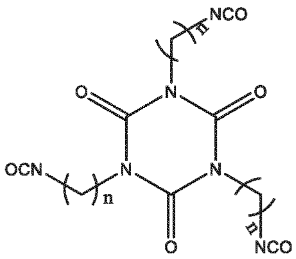 n = 2, 4, 6, 8, 10 , 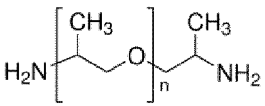 | 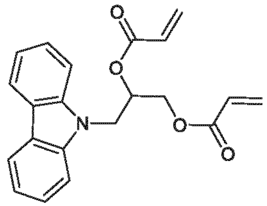 , 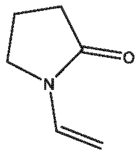 | 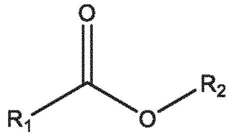 , 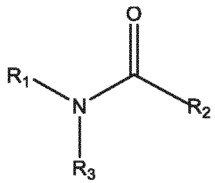 , 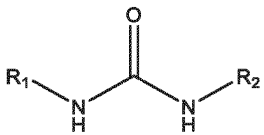 |
| Embodiment 6 | 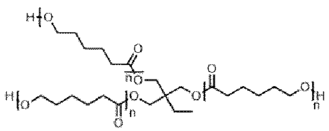 , | 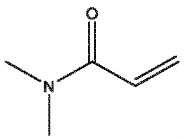 , | 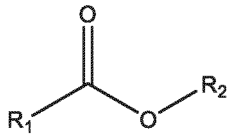 , |

(continued)

| Serial number | First-order monomer | Second-order monomer | Group included in the holographic recording medium and the holographic polymer material |
|---|---|---|---|
| | 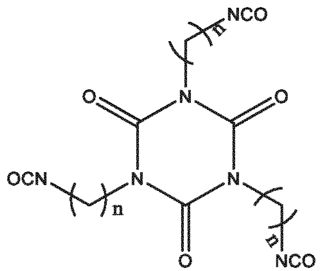 n = 2, 4, 6, 8, 10 , 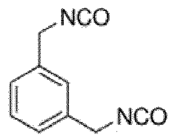 | 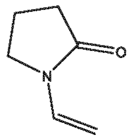 , 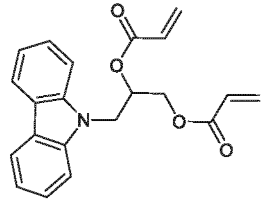 | 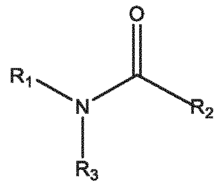 , 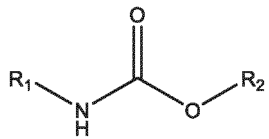 |
| Embodiment 7 | 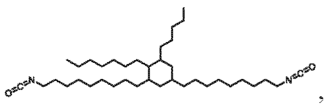 , | 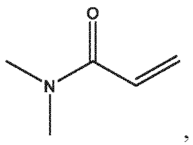 , | 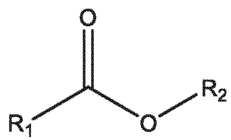 , |

(continued)

| Serial number | First-order monomer | Second-order monomer | Group included in the holographic recording medium and the holographic polymer material |
|---|---|---|---|
| | 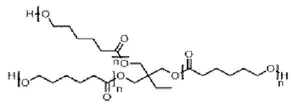 | 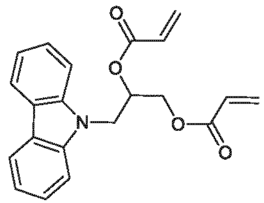 | 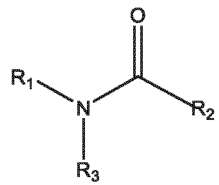 , 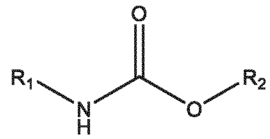 |
| Embodiment 8 | 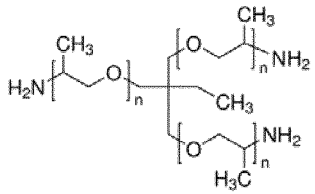 , 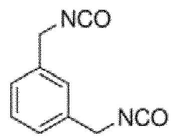 , 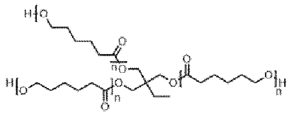 | 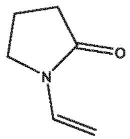 , 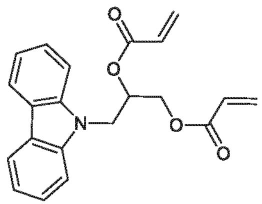 | 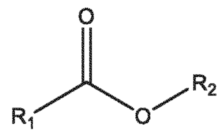 , 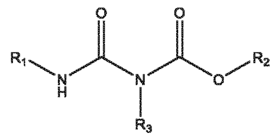 |

(continued)

| Serial number | First-order monomer | Second-order monomer | Group included in the holographic recording medium and the holographic polymer material |
|---|---|---|---|
| Embodiment 9 | 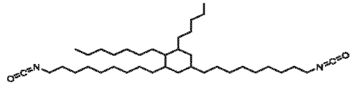 , 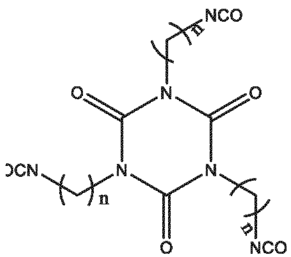 n = 2, 4, 6, 8, 10 , 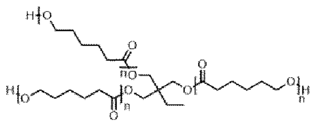 | 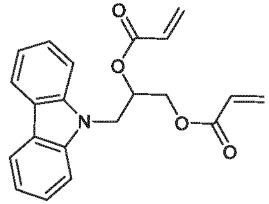 , 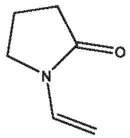 | 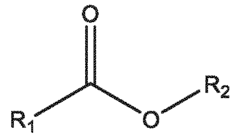 , 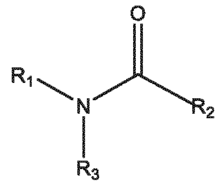 , 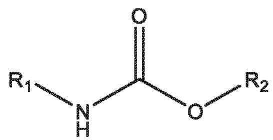 |
| Embodiment 10 | 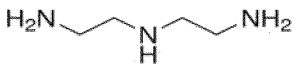 , | 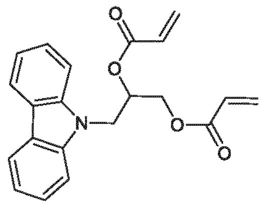 , | 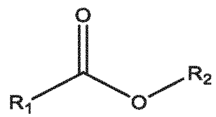 , |

(continued)

| Serial number | First-order monomer | Second-order monomer | Group included in the holographic recording medium and the holographic polymer material |
|---|---|---|---|
| | 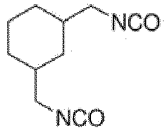 , 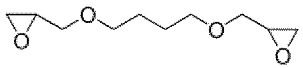 | 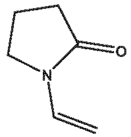 | 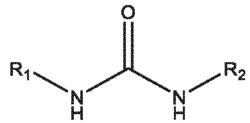 , 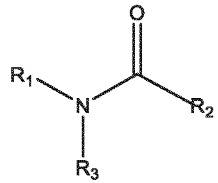 |
| Embodiment 11 | 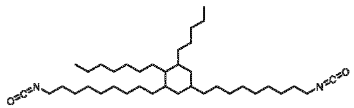 , 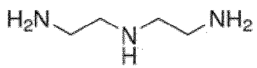 , 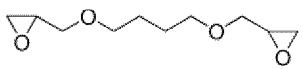 | 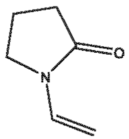 , 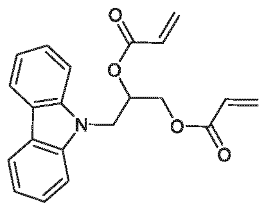 | 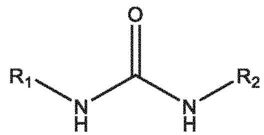 , 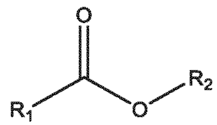 , 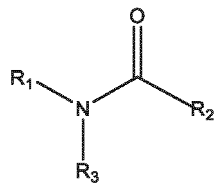 |

(continued)

| Serial number | First-order monomer | Second-order monomer | Group included in the holographic recording medium and the holographic polymer material |
|---|---|---|---|
| Embodiment 12 | 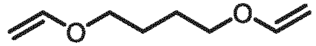, 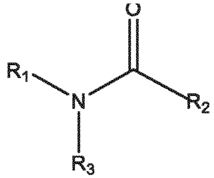, 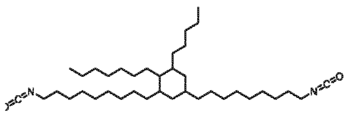 | 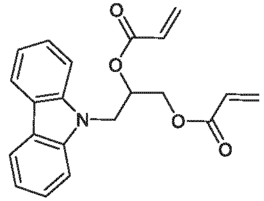, 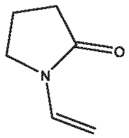 | 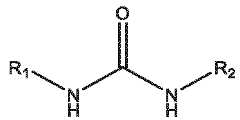, 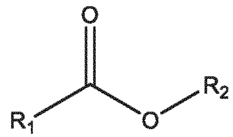, 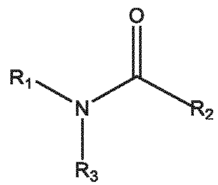 |
| Embodiment 13 | 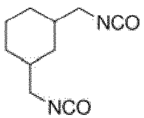, | 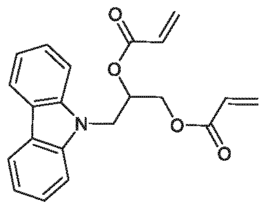, | 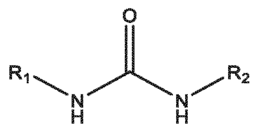, |

(continued)

| Serial number | First-order monomer | Second-order monomer | Group included in the holographic recording medium and the holographic polymer material |
|---|---|---|---|
| | 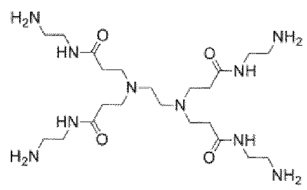 , 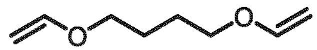 | 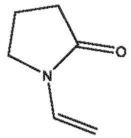 | 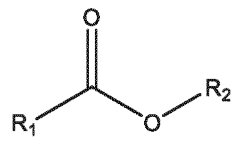 , 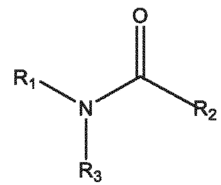 |
| Embodiment 14 | 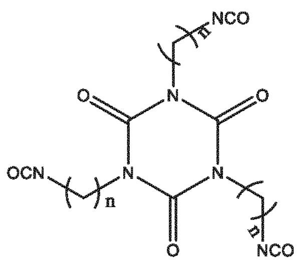 n = 2, 4, 6, 8, 10 , 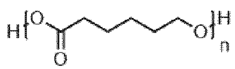 | 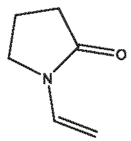 , 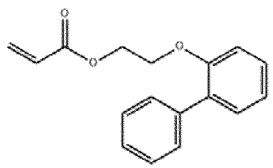 | 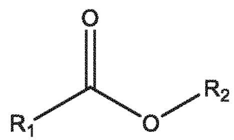 , 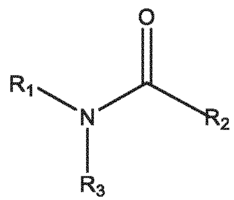 , |

(continued)

| Serial number | First-order monomer | Second-order monomer | Group included in the holographic recording medium and the holographic polymer material |
|---|---|---|---|
| | | | 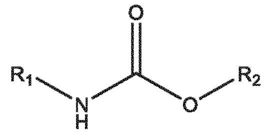 |
| Embodiment 15 | 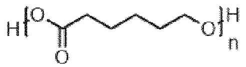 ,<br>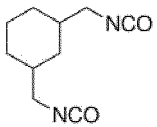 ,<br>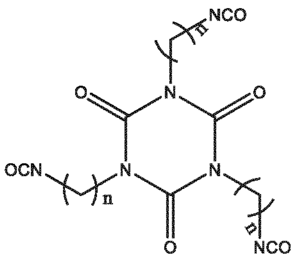<br>n = 2, 4, 6, 8, 10 | 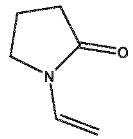 ,<br>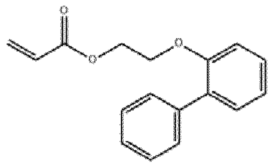 | 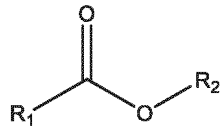 ,<br>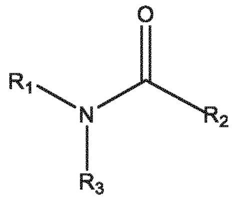 ,<br>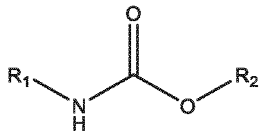 |
| Embodiment 16 | 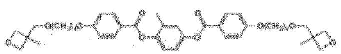 | 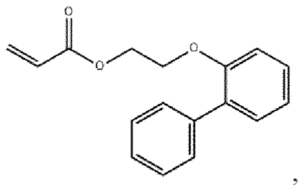 , | 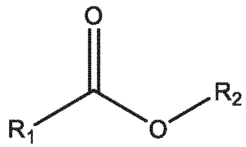 , |

(continued)

| Serial number | First-order monomer | Second-order monomer | Group included in the holographic recording medium and the holographic polymer material |
|---|---|---|---|
| | | 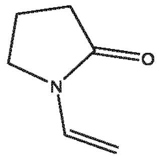 | 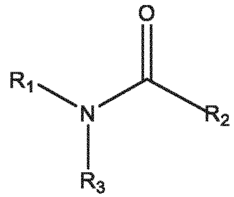 |
| Embodiment 17 | 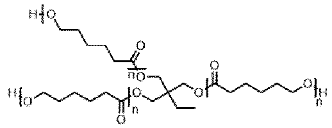 , 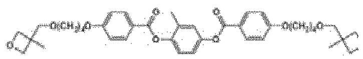 | 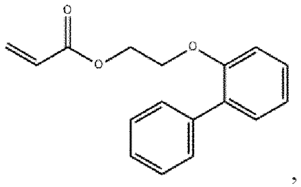 , 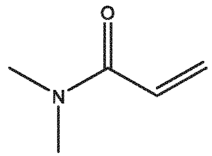 | 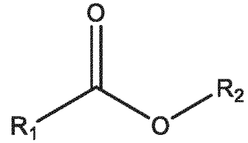 , 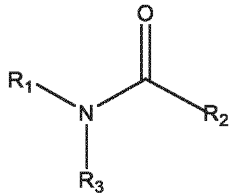 |
| Embodiment 18 | 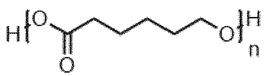 , | 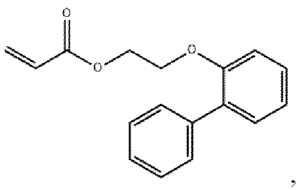 , | 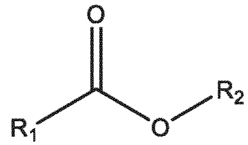 , |

(continued)

| Serial number | First-order monomer | Second-order monomer | Group included in the holographic recording medium and the holographic polymer material |
|---|---|---|---|
| | 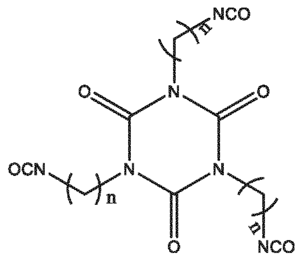 n = 2, 4, 6, 8, 10 , 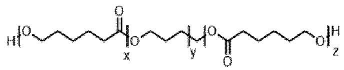 | 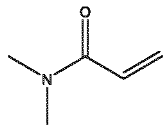 | 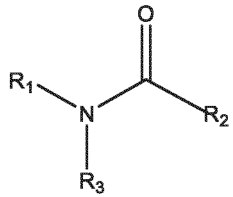 , 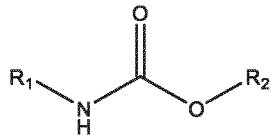 |
| Embodiment 19 | 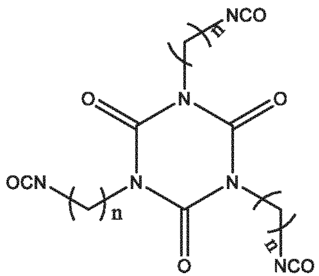 n = 2, 4, 6, 8, 10 , | 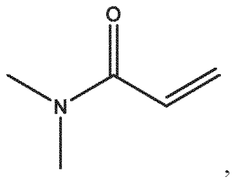 , | 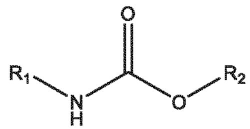 , 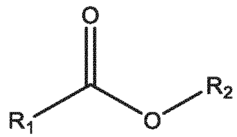 , |

(continued)

| Serial number | First-order monomer | Second-order monomer | Group included in the holographic recording medium and the holographic polymer material |
|---|---|---|---|
| | 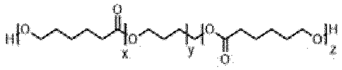 | 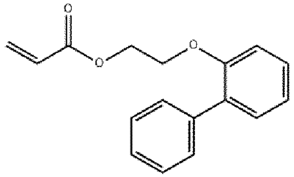 | 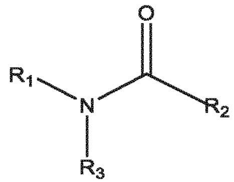 |
| Embodiment 20 | 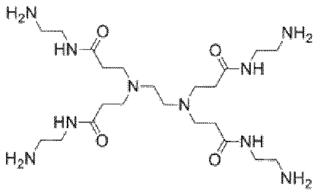 , 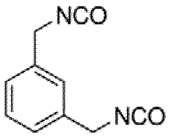 | 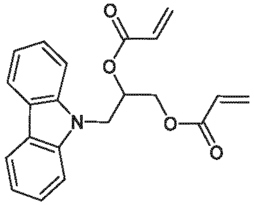 , 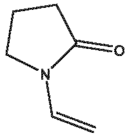 | 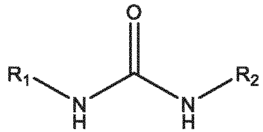 , 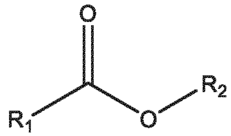 , 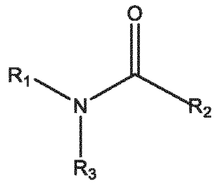 |
| Embodiment 21 | 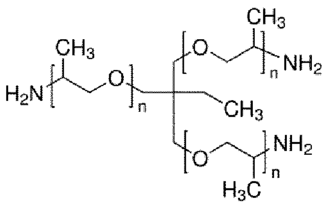 , | 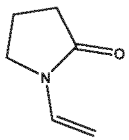 , | 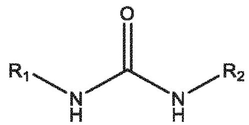 , |

(continued)

| Serial number | First-order monomer | Second-order monomer | Group included in the holographic recording medium and the holographic polymer material |
|---|---|---|---|
| | 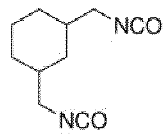 | 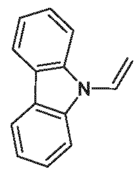 | 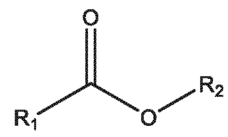 , 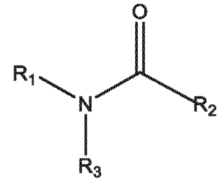 |
| Embodiment 22 | 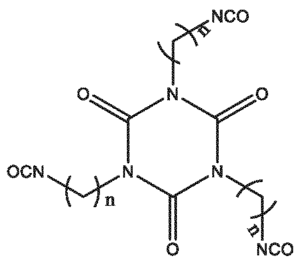 n = 2, 4, 6, 8, 10 , | 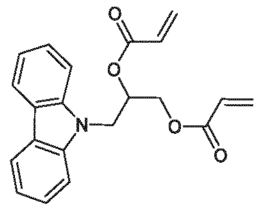 , 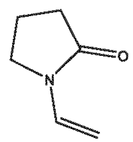 | 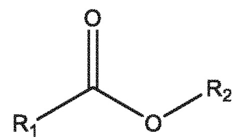 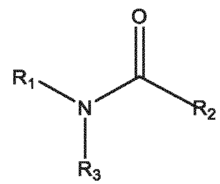 |

(continued)

| Serial number | First-order monomer | Second-order monomer | Group included in the holographic recording medium and the holographic polymer material |
|---|---|---|---|
| | 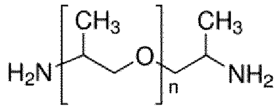 | | 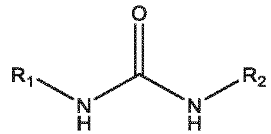 |
| Embodiment 23 | 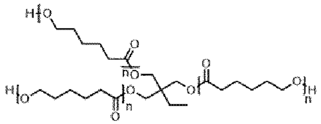 , 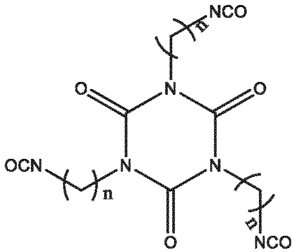 n = 2, 4, 6, 8, 10 , 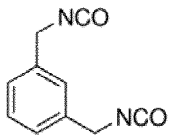 | 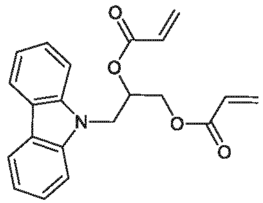 , 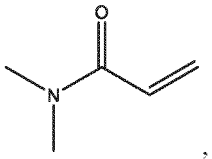 , 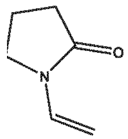 | 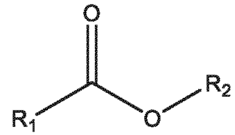 , 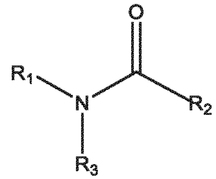 , 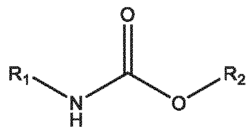 |

(continued)

| Serial number | First-order monomer | Second-order monomer | Group included in the holographic recording medium and the holographic polymer material |
|---|---|---|---|
| Embodiment 24 | 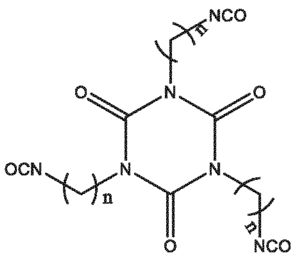 n = 2, 4, 6, 8, 10 , 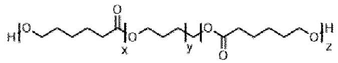 | 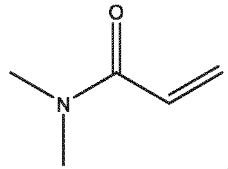 , 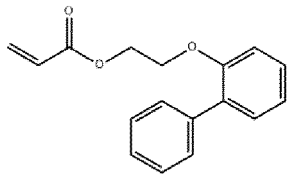 | 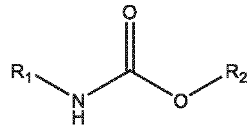 , 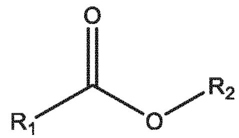 , 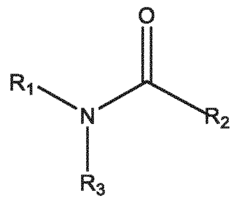 |
| Embodiment 25 | 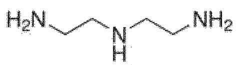 , | 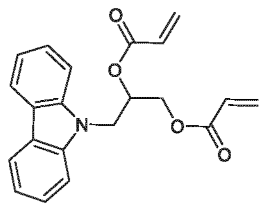 , | 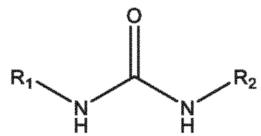 , |

(continued)

| Serial number | First-order monomer | Second-order monomer | Group included in the holographic recording medium and the holographic polymer material |
|---|---|---|---|
| | 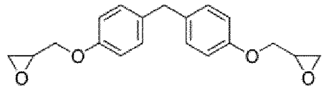, 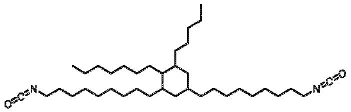 | 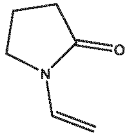 | 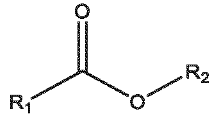, 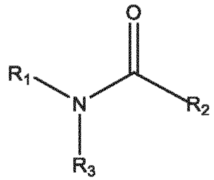 |
| Embodiment 26 | 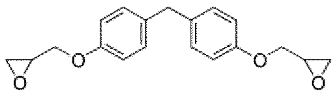, 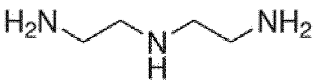, | 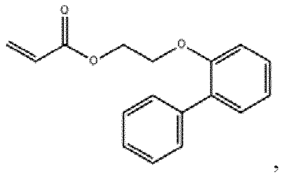, 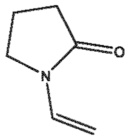 | 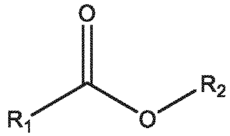 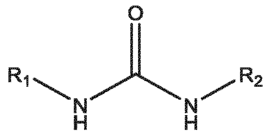 |

(continued)

| Serial number | First-order monomer | Second-order monomer | Group included in the holographic recording medium and the holographic polymer material |
|---|---|---|---|
| | 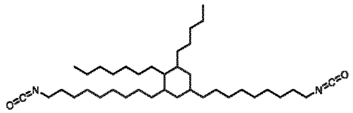 | | 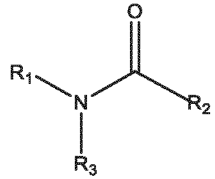 |
| Embodiment 27 | 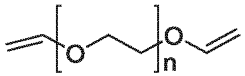 , 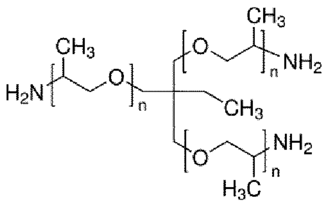 , 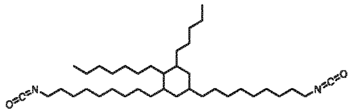 | 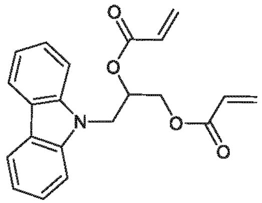 , 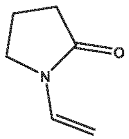 | 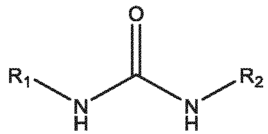 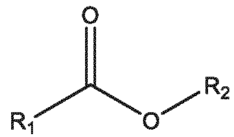 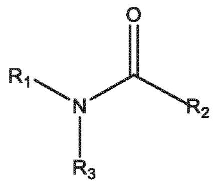 |
| Embodiment 28 | 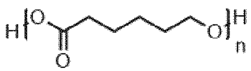 , | 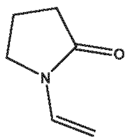 , | 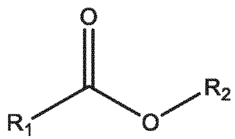 , |

(continued)

| Serial number | First-order monomer | Second-order monomer | Group included in the holographic recording medium and the holographic polymer material |
| --- | --- | --- | --- |
| | 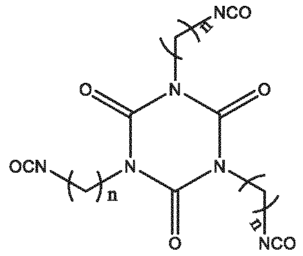 n = 2, 4, 6, 8, 10 , 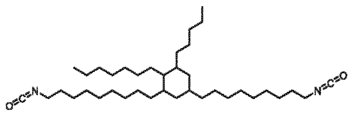 | 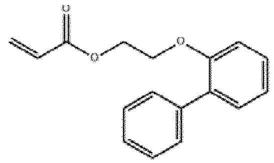 | 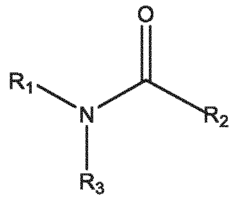 , 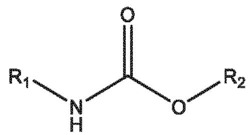 |
| Embodiment 29 | 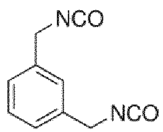 , 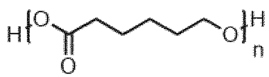 , | 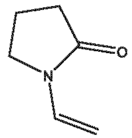 , 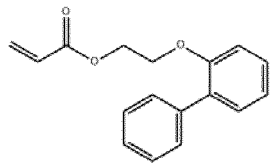 | 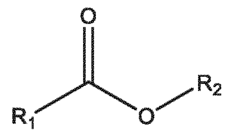 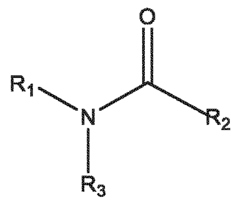 , |

(continued)

| Serial number | First-order monomer | Second-order monomer | Group included in the holographic recording medium and the holographic polymer material |
|---|---|---|---|
| | 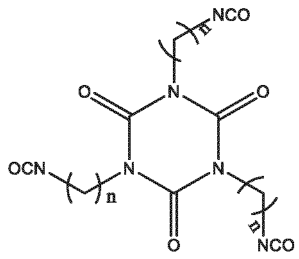 n = 2, 4, 6, 8, 10 | | 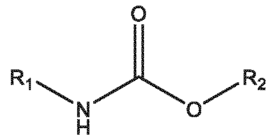 |
| Embodiment 30 | 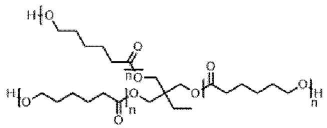 , 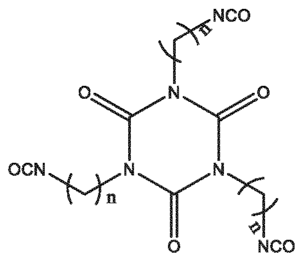 n = 2, 4, 6, 8, 10 | 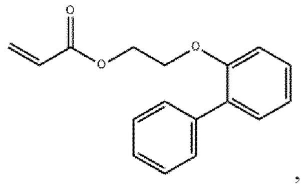 , 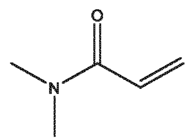 | 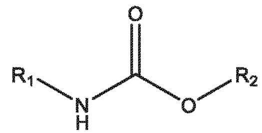 , 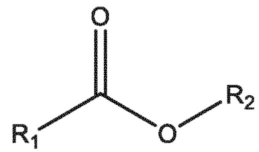 , 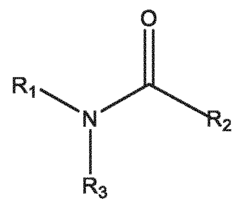 |

Table 2

| Serial number | Photoinitiator | Photoinitiation system (Mass percentage in a total mass) |
|---|---|---|
| Embodiment 2 | Ketocoumarin and amino acid | 0.3 |
| Serial number | Photoinitiator | Photo initiation system (Mass percentage in a total mass) |
| Embodiment 3 | Same as Embodiment 2 | 0.5 |
| Embodiment 4 | Same as Embodiment 2 | 0.7 |
| Embodiment 5 | Same as Embodiment 2 | 0.9 |
| Embodiment 6 | Same as Embodiment 2 | 1.1 |
| Embodiment 7 | Same as Embodiment 2 | 1.3 |
| Embodiment 8 | Same as Embodiment 2 | 1.5 |
| Embodiment 9 | Same as Embodiment 2 | 1.7 |
| Embodiment 10 | Same as Embodiment 2 | 1.9 |
| Embodiment 11 | Rose bengal and N-methyldiethanolamine | 2.1 |
| Embodiment 12 | Same as Embodiment 11 | 2.9 |
| Embodiment 13 | Same as Embodiment 11 | 2.7 |
| Embodiment 14 | Same as Embodiment 2 | 2.5 |
| Embodiment 15 | Same as Embodiment 2 | 2.3 |
| Embodiment 16 | Methylene blue and triazine compound | 2 |
| Embodiment 17 | Same as Embodiment 2 | 0.3 |
| Embodiment 18 | Same as Embodiment 2 | 0.5 |
| Embodiment 19 | Same as Embodiment 2 | 0.9 |
| Embodiment 20 | Same as Embodiment 2 | 1.1 |
| Embodiment 21 | Same as Embodiment 2 | 1.3 |
| Embodiment 22 | Same as Embodiment 2 | 1.5 |
| Embodiment 23 | Same as Embodiment 2 | 1.7 |
| Embodiment 24 | Same as Embodiment 2 | 1.9 |
| Embodiment 25 | Rose bengal and N-methyldiethanolamine | 2.3 |
| Embodiment 26 | Same as Embodiment 25 | 2.5 |
| Embodiment 27 | Same as Embodiment 25 | 2.7 |
| Embodiment 28 | Ketocoumarin and amino acid | 2.1 |
| Embodiment 29 | Same as Embodiment 28 | 1.9 |
| Embodiment 30 | Same as Embodiment 28 | 0.7 |

Table 3

| Serial number | Coherent laser wavelength (nm) | Light intensity (milliwatt/ square centimeter) | Coherent laser time (s) | Post-curing time (minutes) | Post-treatment mode |
|---|---|---|---|---|---|
| Embodiment 2 | 460 | 6 | 10 | 10 | High-pressure mercury lamp |
| Embodiment 3 | 460 | 6 | 10 | 10 | High-pressure mercury lamp |
| Embodiment 4 | 460 | 6 | 10 | 10 | High-pressure mercury lamp |
| Embodiment 5 | 460 | 6 | 10 | 10 | High-pressure mercury lamp |
| Embodiment 6 | 460 | 6 | 10 | 10 | High-pressure mercury lamp |
| Embodiment 7 | 460 | 6 | 10 | 10 | High-pressure mercury lamp |
| Embodiment 8 | 460 | 6 | 10 | 10 | High-pressure mercury lamp |
| Embodiment 9 | 460 | 6 | 10 | 10 | High-pressure mercury lamp |
| Embodiment 10 | 460 | 6 | 10 | 10 | High-pressure mercury lamp |
| Embodiment 11 | 532 | 6 | 10 | 10 | High-pressure mercury lamp |
| Embodiment 12 | 532 | 6 | 10 | 10 | High-pressure mercury lamp |
| Embodiment 13 | 532 | 6 | 10 | 10 | High-pressure mercury lamp |
| Embodiment 14 | 460 | 6 | 10 | 10 | High-pressure mercury lamp |
| Embodiment 15 | 460 | 6 | 10 | 10 | High-pressure mercury lamp |
| Embodiment 16 | 460 | 6 | 10 | 10 | High-pressure mercury lamp |
| Embodiment 17 | 460 | 6 | 10 | 10 | High-pressure mercury lamp |
| Embodiment 18 | 460 | 6 | 10 | 10 | High-pressure mercury lamp |
| Embodiment 19 | 460 | 6 | 20 | 10 | High-pressure mercury lamp |
| Embodiment 20 | 460 | 6 | 5 | 20 | High-pressure mercury lamp |
| Embodiment 21 | 460 | 6 | 2 | 10 | High-pressure mercury lamp |
| Embodiment 22 | 460 | 12 | 10 | 10 | High-pressure mercury lamp |

(continued)

| Serial number | Coherent laser wavelength (nm) | Light intensity (milliwatt/ square centimeter) | Coherent laser time (s) | Post-curing time (minutes) | Post-treatment mode |
|---|---|---|---|---|---|
| Embodiment 23 | 460 | 3 | 10 | 10 | High-pressure mercury lamp |
| Embodiment 24 | 460 | 9 | 10 | 10 | High-pressure mercury lamp |
| Embodiment 25 | 532 | 6 | 10 | 10 | High-pressure mercury lamp |
| Embodiment 26 | 532 | 6 | 10 | 10 | High-pressure mercury lamp |
| Embodiment 27 | 532 | 6 | 10 | 10 | High-pressure mercury lamp |
| Embodiment 28 | 460 | 6 | 10 | 10 | High-pressure mercury lamp |
| Embodiment 29 | 460 | 6 | 10 | 10 | High-pressure mercury lamp |
| Embodiment 30 | 460 | 6 | 10 | 10 | High-pressure mercury lamp |

Performance parameters of the holographic polymer materials prepared according to Embodiments 1 to 30 are separately tested. Test results are listed in Table 4.

A specific test process of each test item is as follows.

(1) A structure of the holographic polymer material is determined by using an infrared spectrometer.

It should be noted that a sample of the holographic polymer material is scanned in a wave number scanning range of 400 $cm^{-1}$ to 4000 $cm^{-1}$ by using an infrared light source in the infrared spectrometer, to obtain the infrared spectrum.

The following uses the infrared spectrum in Embodiment 1 as an example to describe the peak area of the first characteristic absorption peak and the peak area of the second characteristic absorption peak in this application. First, a baseline and a spectral interval of a characteristic absorption peak are determined. The baseline is a tangent of lowest points on two sides of the characteristic absorption peak. The spectral interval of the characteristic absorption peak is a wave number range of the characteristic absorption peak. A peak area of the characteristic absorption peak is an area surrounded by an absorption peak curve and the baseline, for example, a peak area A of the first characteristic absorption peak and a peak area of the second characteristic absorption peak in FIG. 6. A ratio of A to B is 1.7.

(2) Optical performance of the holographic polymer material is measured by using an ultraviolet-visible spectrophotometer. The thickness of the film ranges from 10 μm to 30 μm. A transmittance is a transmittance T at a wavelength of 400 nm to 800 nm.

The following uses the diagram of the ultraviolet-visible absorption spectrum in Embodiment 1 as an example to describe calculation of diffraction efficiency in this application. As shown in FIG. 7, a minimum transmittance ($T_B$) of a reflection peak and a transmittance ($T_A$) of the baseline are first determined. The transmittance of the baseline is a vertical coordinate value of an intersection point between a peak value of the minimum transmittance and the baseline. Then, the diffraction efficiency is calculated based on the following formula:

$$\eta = \frac{T_A - T_B}{T_A} \times 100\%$$

FIG. 8 is a diagram of an infrared spectrum of a holographic polymer material prepared according to Embodiment 3. FIG. 9 is a diagram of an ultraviolet-visible absorption spectrum of the holographic polymer material prepared according to Embodiment 3. FIG. 10 is a diagram of an infrared spectrum of a holographic polymer material prepared according

to Embodiment 5. FIG. 11 is a diagram of an ultraviolet-visible absorption spectrum of the holographic polymer material prepared according to Embodiment 5. FIG. 12 is a diagram of an infrared spectrum of a holographic polymer material prepared according to Embodiment 28. FIG. 13 is a diagram of an ultraviolet-visible absorption spectrum of the holographic polymer material prepared according to Embodiment 28. FIG. 14 is a diagram of an infrared spectrum of a holographic polymer material prepared according to Embodiment 30. FIG. 15 is a diagram of an ultraviolet-visible absorption spectrum of the holographic polymer material prepared according to Embodiment 30.

**Table 4**

| Serial number | Ratio of A to B calculated based on the diagram of the infrared spectrum, where a peak area between wave numbers 1760 and 1702 is recorded as A, and a peak area between wave numbers 1702 and 1640 is recorded as B | Diffraction efficiency calculated based on the ultraviolet-visible absorption spectrum (%) | Minimum transmittance of the holographic polymer material in a band of 400 nm to 800 nm except the diffraction peak based on the ultraviolet-visible absorption spectrum (%) |
|---|---|---|---|
| Embodiment 1 | 1.7 | 90 | 90 |
| Embodiment 2 | 5 | 85 | 88 |
| Embodiment 3 | 4 | 93 | 82 |
| Embodiment 4 | 3 | 92 | 92 |
| Embodiment 5 | 2.5 | 93 | 90 |
| Embodiment 6 | 2.0 | 95 | 91 |
| Embodiment 7 | 1.5 | 95 | 90 |
| Embodiment 8 | 1.3 | 97 | 93 |
| Embodiment 9 | 1.2 | 94 | 92 |
| Embodiment 10 | 1.1 | 88 | 80 |
| Embodiment 11 | 1.0 | 82 | 85 |
| Embodiment 12 | 1.6 | 92 | 87 |
| Embodiment 13 | 1.5 | 89 | 88 |
| Embodiment 14 | 1.3 | 90 | 89 |
| Embodiment 15 | 1.0 | 87 | 81 |
| Embodiment 16 | 1.5 | 87 | 80 |
| Embodiment 17 | 1.3 | 89 | 88 |

(continued)

| Serial number | Ratio of A to B calculated based on the diagram of the infrared spectrum, where a peak area between wave numbers 1760 and 1702 is recorded as A, and a peak area between wave numbers 1702 and 1640 is recorded as B | Diffraction efficiency calculated based on the ultraviolet-visible absorption spectrum (%) | Minimum transmittance of the holographic polymer material in a band of 400 nm to 800 nm except the diffraction peak based on the ultraviolet-visible absorption spectrum (%) |
|---|---|---|---|
| Embodiment 18 | 1.0 | 80 | 83 |
| Embodiment 19 | 1.5 | 98 | 84 |
| Embodiment 20 | 1.5 | 86 | 88 |
| Embodiment 21 | 1.5 | 80 | 80 |
| Embodiment 22 | 1.5 | 94 | 91 |
| Embodiment 23 | 1.5 | 85 | 84 |
| Embodiment 24 | 1.5 | 90 | 88 |
| Embodiment 25 | 0.9 | 27 | 25 |
| Embodiment 26 | 0.7 | 0 | 10 |
| Embodiment 27 | 0.3 | 0 | 6 |
| Embodiment 28 | 0.9 | 11 | 70 |
| Embodiment 29 | 0.7 | 10 | 15 |
| Embodiment 30 | 0.5 | 0 | 16 |

Notes: In Embodiments 1 to 30, the ratio of the peak area of the first characteristic absorption peak to the peak area of the second characteristic absorption peak in the infrared spectrum of the holographic polymer material may be controlled by adjusting content of the second-order monomer.

It can be learned from the data in Table 4 that the ratios of the peak area of the first characteristic absorption peak to the peak area of the second characteristic absorption peak included in the diagrams of the infrared spectra of the holographic polymer materials corresponding to Embodiments 1 to 24 range from 1 to 5, diffraction efficiency of the holographic polymer materials is greater than 80%, and transmittances of the holographic polymer materials are greater than 80%. The ratios of the peak area of the first characteristic absorption peak to the peak area of the second characteristic absorption peak included in the diagrams of the infrared spectra of the holographic polymer materials corresponding to Embodiments 25 to 30 range from 0.3 to 1, and diffraction efficiency or transmittances of the holographic polymer materials are low.

Based on a same technical concept, an embodiment of this application further provides a display device, obtained by using the holographic recording medium described in the foregoing embodiments through a photopolymerization reaction, or including the holographic polymer material described in the foregoing embodiments. The display device is, for example, a head up display (head up display, HUD) device.

Based on a same technical concept, an embodiment of this application further provides a storage device,

obtained by using the holographic recording medium described in the foregoing embodiments through a photopolymerization reaction, or including the holographic polymer material described in the foregoing embodiments. The storage device may be, for example, a holographic memory.

Based on a same technical concept, an embodiment of this application further provides an anti-counterfeiting label, obtained by using the holographic recording medium described in the foregoing embodiments through a photopolymerization reaction, or including the holographic polymer material described in the foregoing embodiments.

It should be noted that in this application, unless otherwise specified, all implementations and preferred implementation methods mentioned in this specification may be combined with each other to form a new technical solution. In this application, unless otherwise specified, all technical features and preferred features mentioned in this specification may be combined with each other to form a new technical solution. In this application, unless otherwise specified, the percentage (%) or part is a weight percentage or a weight part relative to the composition. In this application, unless otherwise specified, the involved components or preferred components thereof may be combined with each other to form a new technical solution. In this application, unless otherwise specified, a value range "a to b" indicates an abbreviated representation of any real number combination between a and b, and includes a and b, where both a and b are real numbers. For example, a value range "1 to 5" indicates that all real numbers from "1 to 5" are listed in this specification, and "1 to 5" is merely an abbreviated representation of a combination of these values. The "range" disclosed in this application is in a form of a lower limit and an upper limit, and may be one or more lower limits and one or more upper limits. In this application, unless otherwise specified, reactions or operation steps may be performed in sequence, or may not be performed in sequence. Optionally, reaction methods in this specification are performed in sequence.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A holographic recording medium, comprising a first-order crosslinked network, a photoinitiator, and a second-order monomer, wherein

    the first-order crosslinked network provides a mechanical support for the holographic recording medium, the second-order monomer is a monomer with a free radical reactivity, and the photoinitiator is used to absorb light and generate a free radical that enables the second-order monomer to be polymerized; and

    the holographic recording medium comprises at least one of the following: an ester group (1), a urethane group (II), a carbamido group (III), an allophanate group (IV), and an amide group (V); and groups linked to the ester group (1), the urethane group (II), the carbamido group (III), the allophanate group (IV), and the amide group (V) are separately selected from at least one of the following: alkyl, alkoxy, alkenyl, or aryl.

2. The holographic recording medium according to claim 1, wherein the second-order monomer accounts for 10% to 80% of a total weight of the holographic recording medium.

3. The holographic recording medium according to claim 1 or 2, wherein after being illuminated, the holographic recording medium comprises at least one of the following: the ester group (I), the urethane group (II), the carbamido group (III), the allophanate group (IV), and the amide group (V).

4. The holographic recording medium according to any one of claims 1 to 3, wherein the holographic recording medium comprises at least one of the following: the ester group (1), the urethane group (II), the carbamido group (III), the allophanate group (IV), and the amide group (V), so that an infrared spectrum of the holographic recording medium comprises a first characteristic absorption peak and a second characteristic absorption peak, wherein a wave number range of the first characteristic absorption peak is 1760 $cm^{-1}$ to 1650 $cm^{-1}$, and a wave number range of the second characteristic absorption peak is 1650 $cm^{-1}$ to 1610 $cm^{-1}$.

5. The holographic recording medium according to claim 4, wherein a ratio of a peak area of the first characteristic absorption peak to a peak area of the second characteristic absorption peak ranges from 5 to 30.

6. The holographic recording medium according to any one of claims 1 to 5, wherein the second-order monomer comprises at least one of the following: acrylate, methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic

acid, and acrylic acid.

**7.** The holographic recording medium according to any one of claims 1 to 6, wherein a refractive index of at least one second-order monomer is greater than 1.505.

**8.** The holographic recording medium according to any one of claims 1 to 7, wherein the first-order crosslinked network is generated through a polymerization reaction of a first-order monomer.

**9.** The holographic recording medium according to any one of claims 1 to 8, wherein the photoinitiator comprises at least one of the following:
benzoin and a derivative thereof, benzyl ketal, an acrylphosphine oxide, ketocoumarin, amino acid, rose bengal, methylene blue, a triazine compound, and alkylamine.

**10.** A holographic polymer material, comprising a first-order crosslinked network and a second-order polymer, wherein the first-order crosslinked network provides a mechanical support for the holographic polymer material, and the second-order polymer is used to form a refractive index distribution for recording holographic information; and
the holographic polymer material comprises at least one of the following: an ester group (I), a urethane group (II), a carbamido group (III), an allophanate group (IV), and an amide group (V); and groups linked to the ester group (I), the urethane group (II), the carbamido group (III), the allophanate group (IV), and the amide group (V) are separately selected from at least one of the following: alkyl, alkoxy, alkenyl, or aryl.

**11.** The holographic polymer material according to claim 10, wherein when the holographic polymer material is used to manufacture a reflective holographic optical element, a transmittance in a range of 400 nm to 700 nm is greater than 80%, and diffraction efficiency is greater than 80%.

**12.** The holographic polymer material according to claim 10 or 11, wherein the holographic polymer material comprises at least one of the following: the ester group (1), the urethane group (II), the carbamido group (III), the allophanate group (IV), and the amide group (V), so that an infrared spectrum of the holographic polymer material comprises a first characteristic absorption peak and a second characteristic absorption peak, wherein a wave number range of the first characteristic absorption peak is 1760 $cm^{-1}$ to 1702 $cm^{-1}$, and a wave number range of the second characteristic absorption peak is 1702 $cm^{-1}$ to 1640 $cm^{-1}$.

**13.** The holographic polymer material according to claim 12, wherein a ratio of a peak area of the first characteristic absorption peak to a peak area of the second characteristic absorption peak ranges from 0.5 to 5.

**14.** The holographic polymer material according to any one of claims 10 to 13, wherein the second-order polymer is generated by polymerizing a second-order monomer under initiation of a free radical; and the second-order monomer comprises at least one of the following: acrylate, methacrylate, maleate, fumarate, maleimide, acrylamide, vinyltoluene, vinylcarbazole, N-vinylpyrrolidone, N,N-dimethylacrylamide, methacrylonitrile, methacrylamide, methacrylic acid, and acrylic acid.

**15.** The holographic polymer material according to claim 14, wherein a refractive index of at least one second-order monomer is greater than 1.505.

**16.** A method for preparing a holographic polymer material, comprising the following steps:

mixing a first-order monomer, a second-order monomer, and a photoinitiator at room temperature to obtain a mixed solution;
performing curing treatment on the mixed solution, so that the first-order monomer undergoes a polymerization reaction to generate a first-order crosslinked network, to obtain a holographic recording medium; and
exposing the holographic recording medium under coherent light to obtain a holographic polymer material recording holographic information.

**17.** The method according to claim 16, wherein the first-order monomer comprises at least one of the following: polyol, polyepoxy, polyvinyl ether, polyamine, and polyisocyanate.

**18.** The method according to claim 16 or 17, wherein the method further comprises:
performing post-treatment on the holographic polymer material, wherein post-treatment comprises illumination or

heating.

**19.** The method according to any one of claims 16 to 18, wherein the method further comprises:
adding a nitrogen-containing polar monomer to the mixed solution.

**20.** The method according to claim 19, wherein the nitrogen-containing polar monomer may be one or more of the following: N-vinylpyrrolidone and N,N-dimethylacrylamide.

**21.** The method according to any one of claims 16 to 20, wherein curing treatment is performed on the mixed solution, so that a thickness of the holographic polymer material is controlled to range from 5 μm to 50 μm.

**22.** A display device, obtained by using the holographic recording medium according to any one of claims 1 to 9 through a photopolymerization reaction, or comprising the holographic polymer material according to any one of claims 10 to 15.

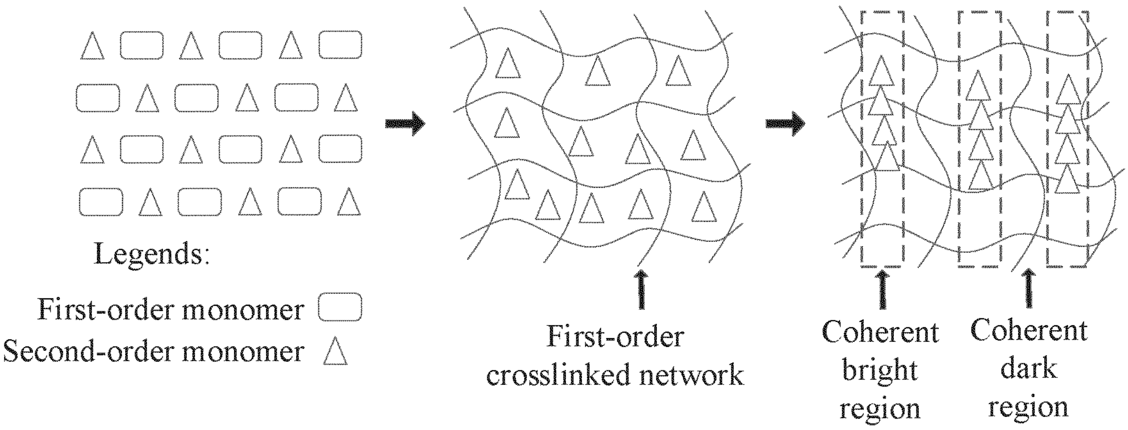
Legends:
First-order monomer
Second-order monomer
First-order crosslinked network
Coherent bright region
Coherent dark region

FIG. 1

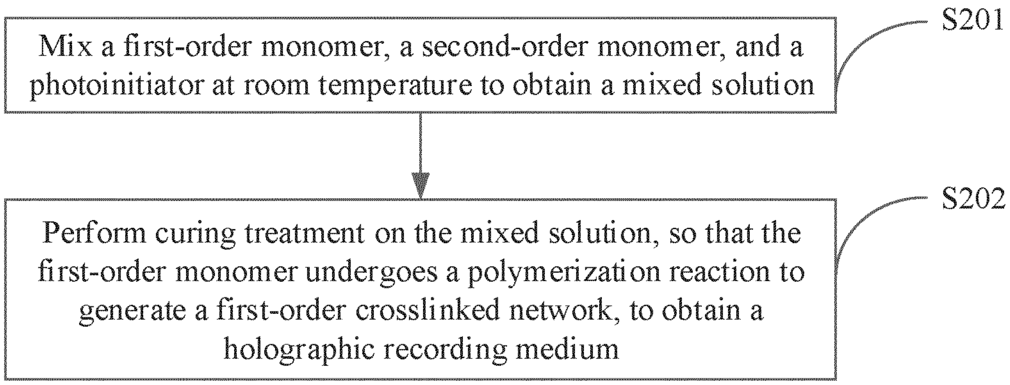
Mix a first-order monomer, a second-order monomer, and a photoinitiator at room temperature to obtain a mixed solution
S201
Perform curing treatment on the mixed solution, so that the first-order monomer undergoes a polymerization reaction to generate a first-order crosslinked network, to obtain a holographic recording medium
S202

FIG. 2

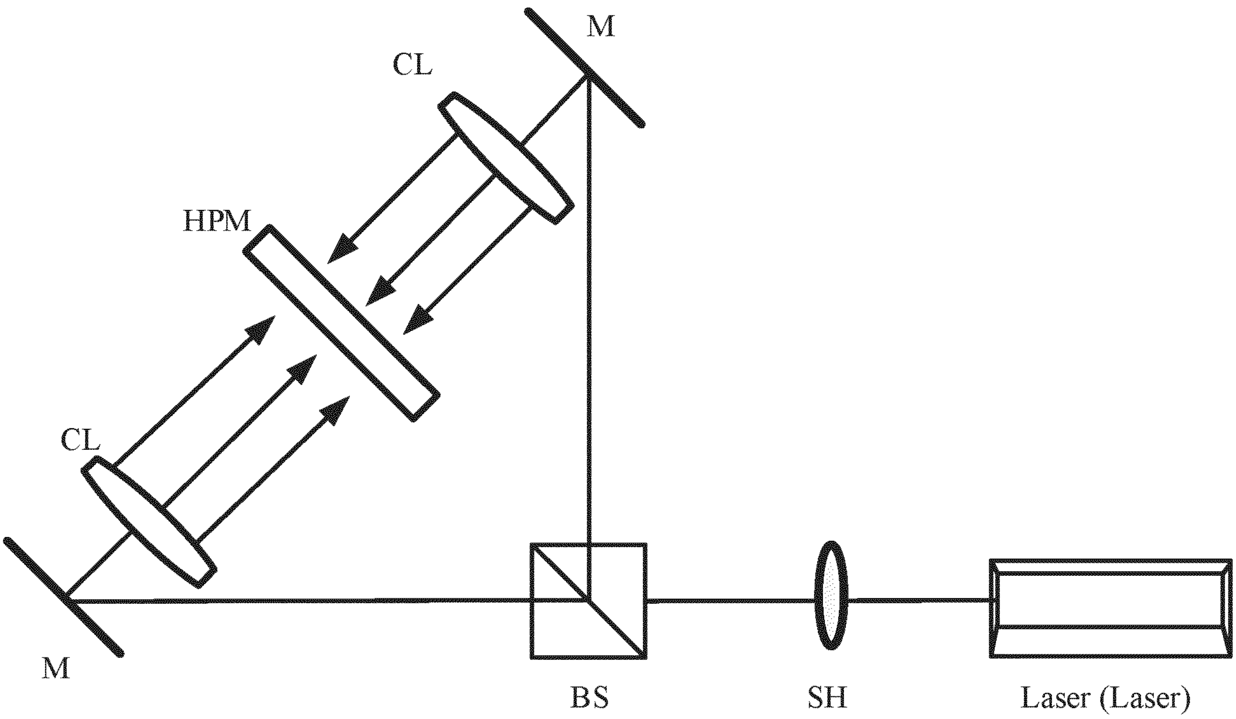
M
CL
HPM
CL
M
BS
SH
Laser (Laser)

FIG. 3

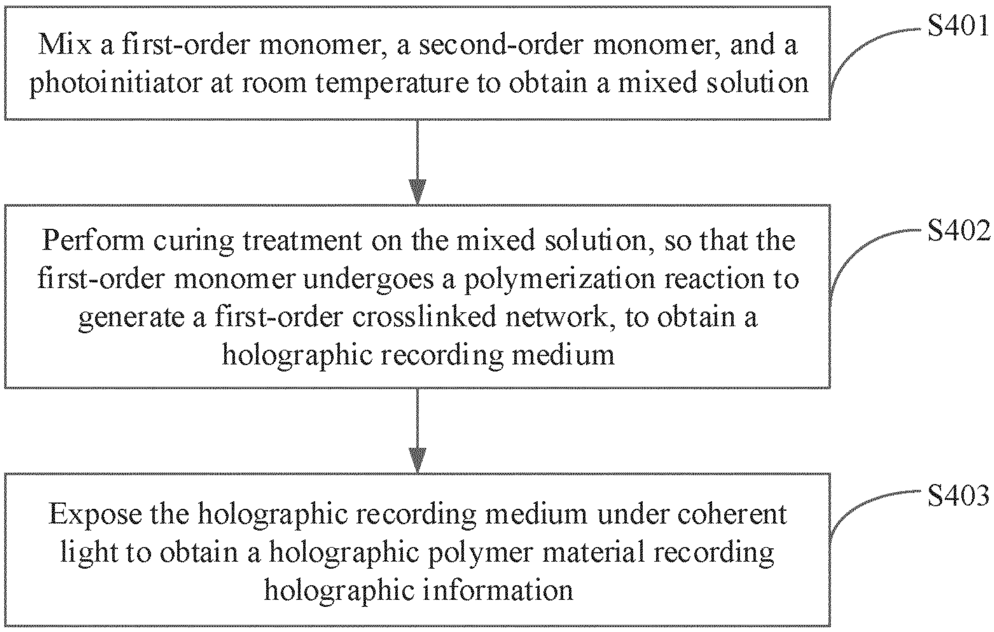
Mix a first-order monomer, a second-order monomer, and a photoinitiator at room temperature to obtain a mixed solution
S401
Perform curing treatment on the mixed solution, so that the first-order monomer undergoes a polymerization reaction to generate a first-order crosslinked network, to obtain a holographic recording medium
S402
Expose the holographic recording medium under coherent light to obtain a holographic polymer material recording holographic information
S403

FIG. 4

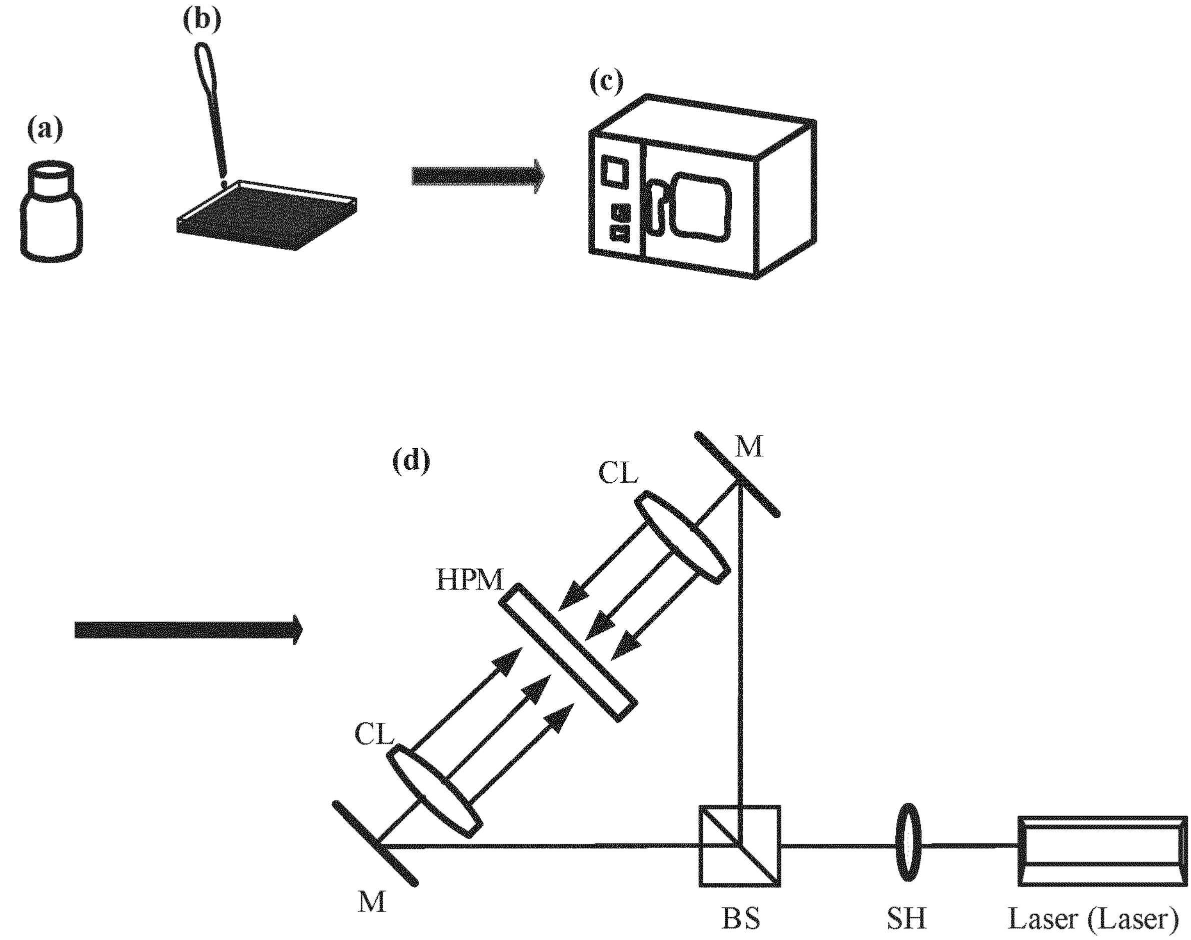
(a)
(b)
(c)
(d)
M
CL
HPM
CL
M
BS
SH
Laser (Laser)

FIG. 5

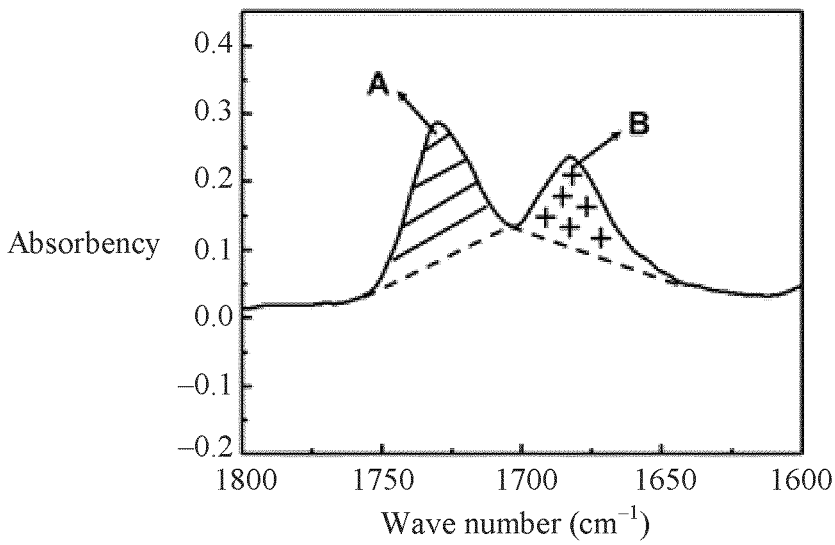
Absorbency
0.4
0.3
0.2
0.1
0.0
–0.1
–0.2
A
B
1800
1750
1700
1650
1600
Wave number (cm$^{-1}$)

FIG. 6

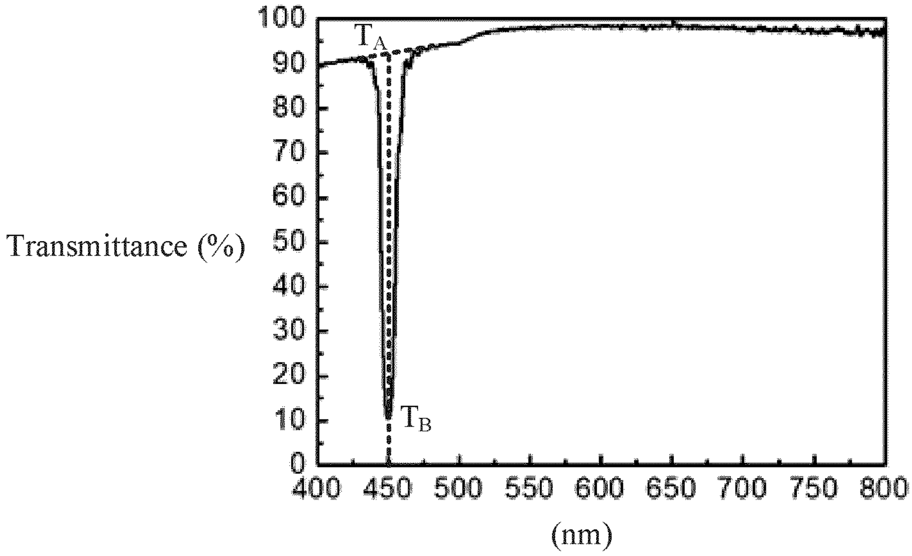
Transmittance (%)
100
90
80
70
60
50
40
30
20
10
0
T_A
T_B
400
450
500
550
600
650
700
750
800
(nm)

FIG. 7

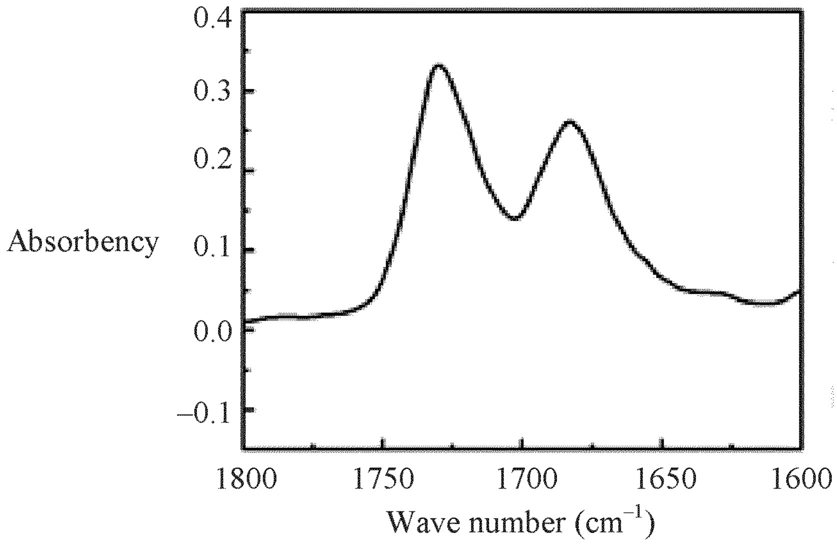
Absorbency
0.4
0.3
0.2
0.1
0.0
–0.1
1800
1750
1700
1650
1600
Wave number (cm⁻¹)

FIG. 8

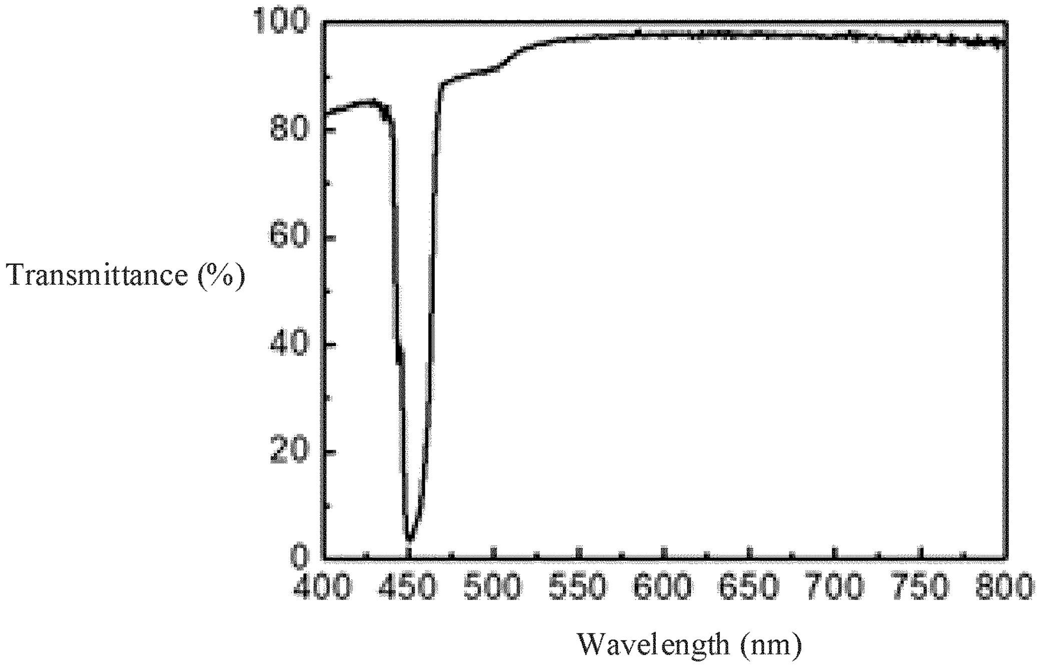
100
80
60
Transmittance (%)
40
20
0
400 450 500 550 600 650 700 750 800
Wavelength (nm)

FIG. 9

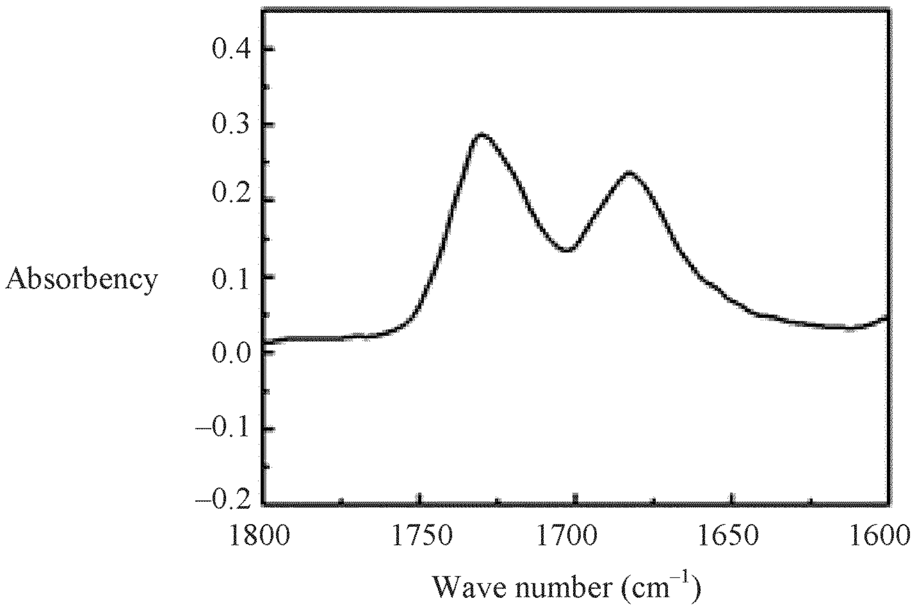
0.4
0.3
0.2
Absorbency
0.1
0.0
−0.1
−0.2
1800 1750 1700 1650 1600
Wave number (cm⁻¹)

FIG. 10

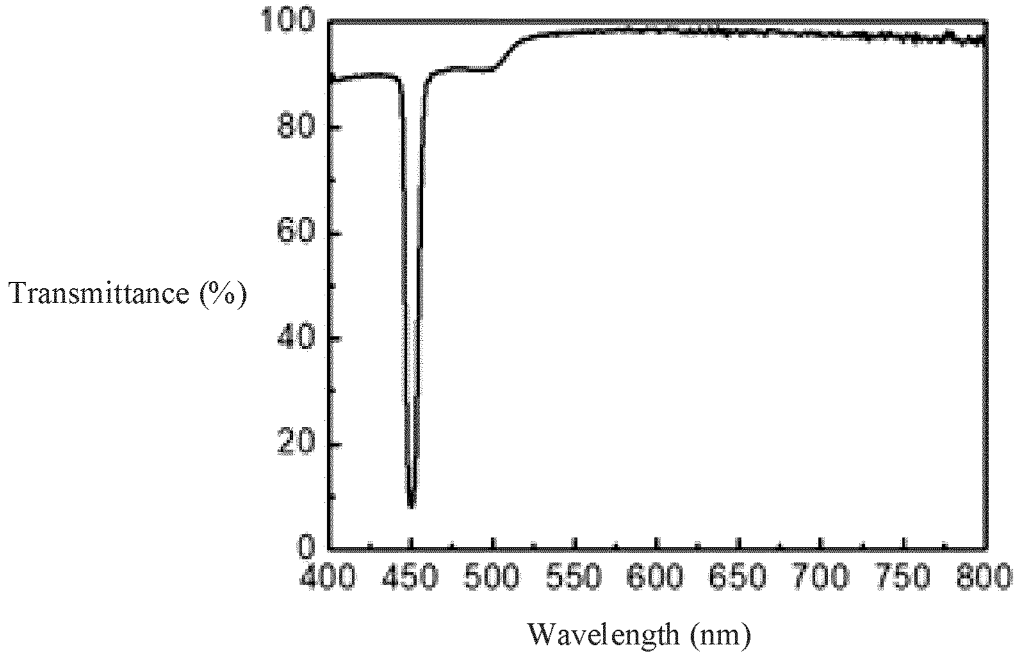
Transmittance (%)
100
80
60
40
20
0
400 450 500 550 600 650 700 750 800
Wavelength (nm)

FIG. 11

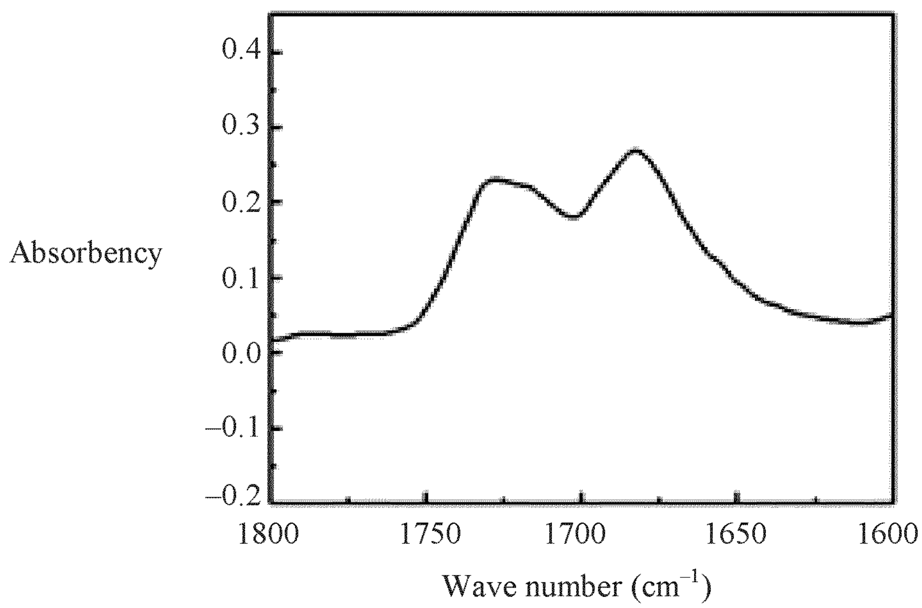
Absorbency
0.4
0.3
0.2
0.1
0.0
−0.1
−0.2
1800 1750 1700 1650 1600
Wave number (cm−1)

FIG. 12

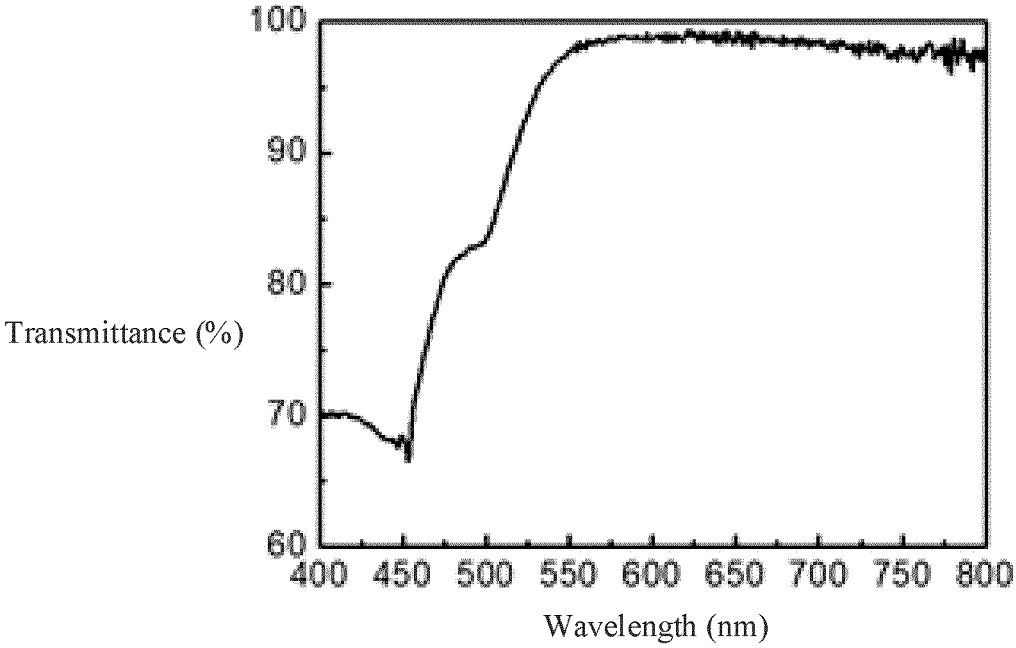
100
90
80
70
60
Transmittance (%)
400 450 500 550 600 650 700 750 800
Wavelength (nm)

FIG. 13

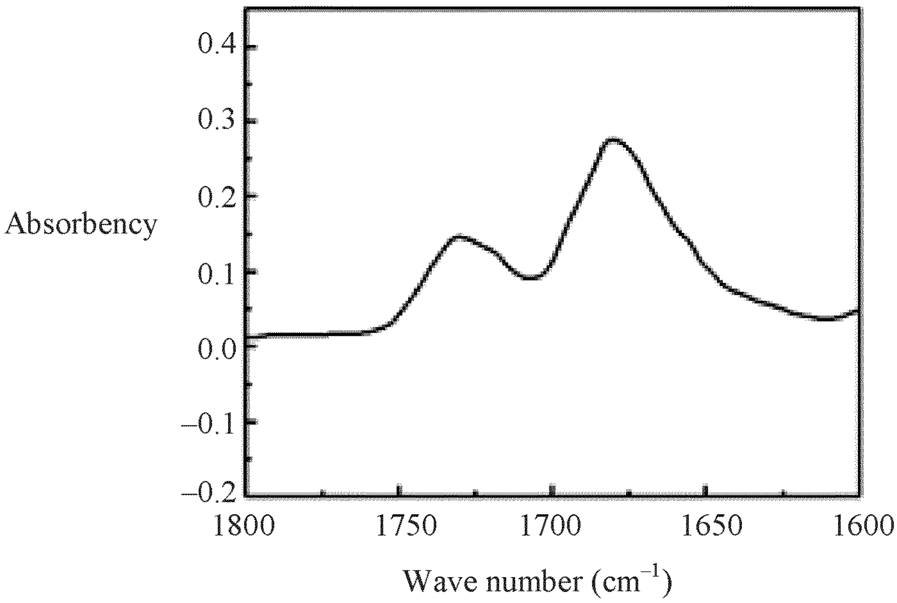
0.4
0.3
0.2
0.1
0.0
−0.1
−0.2
Absorbency
1800 1750 1700 1650 1600
Wave number (cm−1)

FIG. 14

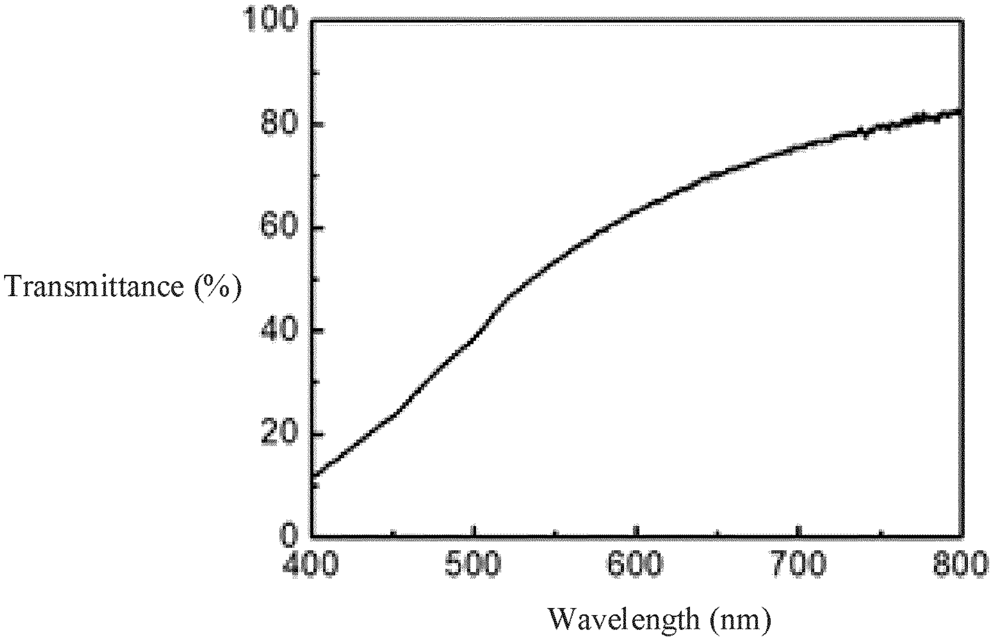
100
80
60
40
20
0
Transmittance (%)
400
500
600
700
800
Wavelength (nm)

FIG. 15

**INTERNATIONAL SEARCH REPORT**

International application No. **PCT/CN2022/085089**

**A. CLASSIFICATION OF SUBJECT MATTER**

G03F 7/027(2006.01)i

According to International Patent Classification (IPC) or to both national classification and IPC

**B. FIELDS SEARCHED**

Minimum documentation searched (classification system followed by classification symbols)

G03F

Documentation searched other than minimum documentation to the extent that such documents are included in the fields searched

Electronic data base consulted during the international search (name of data base and, where practicable, search terms used)

CNABS, VEN, CNTXT, ENTXT, CNKI, ISI, 全息, 交联, 光引发, holographic. crosslink, photo+

**C. DOCUMENTS CONSIDERED TO BE RELEVANT**

| Category* | Citation of document, with indication, where appropriate, of the relevant passages | Relevant to claim No. |
|---|---|---|
| X | CN 101713923 A (BAYER MATERIALSCIENCE AG) 26 May 2010 (2010-05-26) description, paragraphs [0019] to [0032], [0111], and [0127], and embodiments | 1-22 |
| X | CN 101606106 A (NIPPON STEEL CHEMICAL CO. et al.) 16 December 2009 (2009-12-16) embodiments | 1-22 |
| X | CN 101807003 A (BAYER MATERIALSCIENCE AG et al.) 18 August 2010 (2010-08-18) embodiments | 1-22 |
| X | CN 102971677 A (DAICEL CORP.) 13 March 2013 (2013-03-13) embodiments | 1-22 |
| X | CN 107001246 A (COVESTRO DEUTSCHLAND AG) 01 August 2017 (2017-08-01) embodiments | 1-22 |
| X | CN 103222000 A (BAYER INTELLECTUAL PROPERTY GMBH et al.) 24 July 2013 (2013-07-24) embodiments | 1-22 |
| X | CN 104718503 A (DAICEL CORP.) 17 June 2015 (2015-06-17) embodiments | 1-22 |

☑ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **30 June 2022** | **06 July 2022** |
| Name and mailing address of the ISA/CN<br>**China National Intellectual Property Administration (ISA/CN)**<br>**No. 6, Xitucheng Road, Jimenqiao, Haidian District, Beijing 100088, China**<br>Facsimile No. **(86-10)62019451** | Authorized officer<br><br>Telephone No. |

Form PCT/ISA/210 (second sheet) (January 2015)

**INTERNATIONAL SEARCH REPORT**

International application No.
**PCT/CN2022/085089**

**C. DOCUMENTS CONSIDERED TO BE RELEVANT**

| Category* | Citation of document, with indication, where appropriate, of the relevant passages | Relevant to claim No. |
|---|---|---|
| X | JP 2012047787 A (DAICEL CORP.) 08 March 2012 (2012-03-08)<br>embodiments | 1-22 |

Form PCT/ISA/210 (second sheet) (January 2015)

**INTERNATIONAL SEARCH REPORT**
**Information on patent family members**

International application No.
**PCT/CN2022/085089**

| Patent document cited in search report | Publication date (day/month/year) | Patent family member(s) | Publication date (day/month/year) |
|---|---|---|---|
| CN 101713923 A | 26 May 2010 | IN 1957DEL2009 A | 18 June 2010 |
| | | JP 2010111858 A | 20 May 2010 |
| | | KR 20100037557 A | 09 April 2010 |
| | | IL 200996 D0 | 30 June 2010 |
| | | RU 2009136169 A | 10 April 2011 |
| | | BR PI0903847 A2 | 20 July 2010 |
| | | SG 160313 A1 | 29 April 2010 |
| | | EP 2172504 A1 | 07 April 2010 |
| | | AT 517139 T | 15 August 2011 |
| | | US 2010087564 A1 | 08 April 2010 |
| | | TW 201033241 A | 16 September 2010 |
| | | CA 2680974 A1 | 01 April 2010 |
| CN 101606106 A | 16 December 2009 | JP WO2008096712 A1 | 20 May 2010 |
| | | WO 2008096712 A1 | 14 August 2008 |
| | | EP 2110718 A1 | 21 October 2009 |
| | | TW 200846379 A | 01 December 2008 |
| | | KR 20090107085 A | 12 October 2009 |
| | | US 2009310196 A1 | 17 December 2009 |
| CN 101807003 A | 18 August 2010 | KR 20100094385 A | 26 August 2010 |
| | | SG 164335 A1 | 29 September 2010 |
| | | CA 2692848 A1 | 17 August 2010 |
| | | EP 2219073 A1 | 18 August 2010 |
| | | JP 2010191427 A | 02 September 2010 |
| | | BR PI1000341 A2 | 22 March 2011 |
| | | TW 201042371 A | 01 December 2010 |
| | | EP 2219075 A1 | 18 August 2010 |
| | | RU 2010105292 A | 27 August 2011 |
| | | US 2011065827 A1 | 17 March 2011 |
| | | IN 334DEL2010 A | 27 April 2012 |
| CN 102971677 A | 13 March 2013 | JP 2012047787 A | 08 March 2012 |
| | | WO 2012026298 A1 | 01 March 2012 |
| | | TW 201219975 A | 16 May 2012 |
| | | KR 20130138217 A | 18 December 2013 |
| CN 107001246 A | 01 August 2017 | TW 201639812 A | 16 November 2016 |
| | | EP 3230261 A1 | 18 October 2017 |
| | | KR 20170094201 A | 17 August 2017 |
| | | WO 2016091965 A1 | 16 June 2016 |
| | | JP 2018501224 A | 18 January 2018 |
| | | US 2017363957 A1 | 21 December 2017 |
| CN 103222000 A | 24 July 2013 | KR 20130126611 A | 20 November 2013 |
| | | US 2013224634 A1 | 29 August 2013 |
| | | JP 2013543149 A | 28 November 2013 |
| | | EP 2450893 A1 | 09 May 2012 |
| | | TW 201631052 A | 01 September 2016 |
| | | TR 201904304 T4 | 21 May 2019 |
| | | PL 2638544 T3 | 31 July 2019 |
| | | TW 201237119 A | 16 September 2012 |
| | | EP 2638544 A2 | 18 September 2013 |
| | | ES 2717635 T3 | 24 June 2019 |

Form PCT/ISA/210 (patent family annex) (January 2015)

**INTERNATIONAL SEARCH REPORT**
**Information on patent family members**

International application No.
**PCT/CN2022/085089**

| Patent document cited in search report | Publication date (day/month/year) | Patent family member(s) | Publication date (day/month/year) |
|---|---|---|---|
| | | WO 2012062655 A2 | 18 May 2012 |
| | | US 2016054704 A1 | 25 February 2016 |
| CN 104718503 A | 17 June 2015 | TW 201426213 A | 01 July 2014 |
| | | JP 2014081423 A | 08 May 2014 |
| | | US 2015268629 A1 | 24 September 2015 |
| | | KR 20150071700 A | 26 June 2015 |
| | | WO 2014061559 A1 | 24 April 2014 |
| | | EP 2908182 A1 | 19 August 2015 |
| JP 2012047787 A | 08 March 2012 | CN 102971677 A | 13 March 2013 |
| | | WO 2012026298 A1 | 01 March 2012 |
| | | TW 201219975 A | 16 May 2012 |
| | | KR 20130138217 A | 18 December 2013 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202110563230